# EUROPEAN PATENT APPLICATION

(11) **EP 4 411 477 A1**
(43) Date of publication of application: **07.08.2024**
(21) Application number: 22875875.1
(22) Date of filing: 16.09.2022
(51) Int. Cl.: G03F 7/004, G03F 7/038, G03F 7/039, G03F 7/20, G03F 7/32

(54) **ACTIVE-LIGHT-SENSITIVE OR RADIATION-SENSITIVE RESIN COMPOSITION, AND METHOD FOR PRODUCING RESIST PATTERN**

(30) Priority: 29.09.2021 JP 2021159717; 19.01.2022 JP 2022006434
(71) Applicant: FUJIFILM Corporation, Tokyo 106-8620 (JP)
(72) Inventor: TANGO, Naohiro, Haibara-gun, Shizuoka 421-0396 (JP); SHIRAKAWA, Michihiro, Haibara-gun, Shizuoka 421-0396 (JP); YAMAMOTO, Kei, Haibara-gun, Shizuoka 421-0396 (JP)
(74) Representative: HGF
(86) International application number: PCT/JP2022/034674
(87) International publication number: WO 2023/054004

(57) **Abstract**

An object of the present invention to provide an actinic ray-sensitive or radiation-sensitive resin composition that has high preservation stability and is characterized in that when etching treatment is performed using a resist pattern formed from the resist composition as a mask, defects are less likely to occur in a pattern formed. Another object of the present invention is to provide a method for producing a resist pattern.

An actinic ray-sensitive or radiation-sensitive resin composition according to the present invention contains a resin that becomes more polar under the action of acid, a photoacid generator, a compound Y that is at least one selected from the group consisting of a compound represented by formula (1) and a compound represented by formula (2), and a metal atom. The mass ratio of the content of the compound Y to the content of the metal atom is 1.0 × 10 to 1.0 × 10⁹.

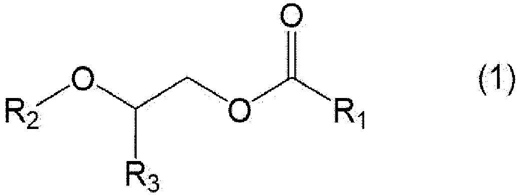

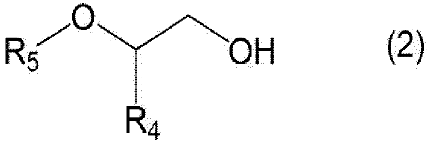

## Description

### BACKGROUND OF THE INVENTION

### 1. Field of the Invention

The present invention relates to an actinic ray-sensitive or radiation-sensitive resin composition and a method for producing a resist pattern.

### 2. Description of the Related Art

In a process for producing a semiconductor device such as an integrated circuit (IC) or a large scale integrated circuit (LSI), lithography micromachining using an actinic ray-sensitive or radiation-sensitive composition (hereinafter also referred to as a "resist composition") has been conventionally performed. In recent years, with increasing integration of integrated circuits, formation of ultrafine patterns in submicron regions or quarter-micron regions has been required.

Accordingly, for miniaturization of semiconductor devices, the wavelengths of exposure light sources have been shortened and the numerical apertures (NAs) of projector lenses have been increased, and exposure devices using a KrF excimer laser having a wavelength of 248 nm or an ArF excimer laser having a wavelength of 193 nm as a light source have been developed. In addition, pattern forming methods using extreme ultraviolet rays (EUV light) or an electron beam (EB) as a light source have also recently been studied.

For example, WO2019/142786A discloses a photosensitive resin laminate including a support film and a photosensitive resin composition layer formed on the support film, the photosensitive resin composition layer including a photosensitive resin composition. The photosensitive resin composition contains an alkali-soluble polymer, a compound having an ethylenically unsaturated double bond, a photopolymerization initiator, and a metal atom, and the content of the metal atom in the photosensitive resin composition layer is 0.005 ppm or more and 70 ppm or less based on the amount of the photosensitive resin composition layer.

### SUMMARY OF THE INVENTION

The present inventors have further studied a resist pattern with a smaller size formed using a resist composition containing a metal atom with reference to the technique described in WO2019/142786A, and found that a pattern formed by performing etching using the resist pattern as a mask and formed in a target layer located below the resist pattern is likely to suffer pattern defects presumably derived from the metal atom. Stability of quality of after storage of a resist composition for a predetermined period of time has also been demanded.

In view of the above circumstances, an object of the present invention is to provide an actinic ray-sensitive or radiation-sensitive resin composition that has high preservation stability and is characterized in that when etching treatment is performed using a resist pattern formed from the resist composition as a mask, defects are less likely to occur in a pattern formed.

Another object of the present invention is to provide a method for producing a resist pattern.

The present inventors have found that the above objects can be achieved by the following configurations.
[1] An actinic ray-sensitive or radiation-sensitive resin composition containing:
   a resin that becomes more polar under action of acid;
   a photoacid generator;
   a compound Y that is at least one selected from the group consisting of a compound represented by formula (1) described later and a compound represented by formula (2) described later; and
   a metal atom, wherein a mass ratio of a content of the compound Y to a content of the metal atom is 1.0 × 10 to 1.0 × 10⁹.
[2] The actinic ray-sensitive or radiation-sensitive resin composition according to [1], satisfying requirement 1 described later.
[3] The actinic ray-sensitive or radiation-sensitive resin composition according to [1] or [2], wherein the resin has a repeating unit represented by formula (Y) described later.
[4] The actinic ray-sensitive or radiation-sensitive resin composition according to any one of [1] to [3], further containing propylene glycol methyl ether acetate.
[5] The actinic ray-sensitive or radiation-sensitive resin composition according to any one of [1] to [4], further containing a peroxide, wherein a content of the peroxide is 100 mass ppm or less relative to a total mass of the actinic ray-sensitive or radiation-sensitive resin composition.
[6] The actinic ray-sensitive or radiation-sensitive resin composition according to any one of [1] to [5], being used for EUV exposure.
[7] A method for producing a resist pattern, having a resist film formation step of forming a resist film on a substrate using the actinic ray-sensitive or radiation-sensitive resin composition according to any one of [1] to [6], an exposure step of exposing the resist film, and a development step of developing the exposed resist film using a developer.
[8] The method for producing a resist pattern according to [7], wherein the developer includes an ester solvent and a hydrocarbon solvent.
[9] The method for producing a resist pattern according to [7] or [8], wherein the developer includes butyl acetate and undecane.

The present invention can provide an actinic ray-sensitive or radiation-sensitive resin composition that has high preservation stability and is characterized in that when etching treatment is performed using a resist pattern formed from the resist composition as a mask, defects are less likely to occur in a pattern formed.

The present invention can also provide a method for producing a resist pattern.

### DESCRIPTION OF THE PREFERRED EMBODIMENTS

Hereinafter, the present invention will be described in detail.

It should be appreciated that although the following description of constituent features may be made in the context of a representative embodiment of the present invention, the present invention is not limited to the embodiment.

Regarding expressions of groups (atomic groups) in the present specification, an expression not specified as substituted or unsubstituted encompasses a group having no substituents and also a group having a substituent without departing from the spirit of the present invention. For example, an "alkyl group" encompasses not only an alkyl group having no substituents (an unsubstituted alkyl group) but also an alkyl group having a substituent (a substituted alkyl group). The term "organic group" in the present specification refers to a group including at least one carbon atom.

The substituent is preferably a monovalent substituent unless otherwise specified.

The term "actinic ray" or "radiation" in the present specification means, for example, an emission line spectrum of a mercury lamp, far ultraviolet rays represented by excimer lasers, extreme ultraviolet rays (EUV light), X-rays, or an electron beam (EB). The term "light" in the present specification means an actinic ray or a radiation.

The term "exposure" in the present specification includes, unless otherwise specified, not only exposure with, for example, an emission line spectrum of a mercury lamp, far ultraviolet rays represented by excimer lasers, extreme ultraviolet rays, X-rays, or EUV light but also patterning with a corpuscular beam such as an electron beam or an ion beam.

In the present specification, the term "to" is used to mean that numerical values given before and after "to" are included as lower and upper limit values.

The bonding direction of a divalent group given in the present specification is not limited unless otherwise specified. For example, in a compound represented by a formula "X-Y-Z" where Y is -COO-, Y may be -CO-O- or -O-CO-. This compound may be represented as "X-CO-O-Z" or "X-O-CO-Z".

In the present specification, (meth)acrylate represents acrylate and methacrylate, and (meth)acrylic represents acrylic and methacrylic.

In the present specification, a weight-average molecular weight (Mw), a number-average molecular weight (Mn), and a dispersity (also referred to as a molecular weight distribution) (Mw/Mn) of a resin are defined as polystyrene equivalent values determined using a gel permeation chromatography (GPC) apparatus (HLC-8120GPC manufactured by Tosoh Corporation) by GPC measurement (solvent: tetrahydrofuran, flow rate (sample injection volume): 10 µL, column: TSK gel Multipore HXL-M manufactured by Tosoh Corporation, column temperature: 40°C, flow rate: 1.0 mL/min, detector: differential refractive index detector).

In the present specification, an acid dissociation constant (pKa) represents pKa in an aqueous solution, specifically, a value determined using a software package 1 below by calculation of the Hammett substituent constant and values based on a database of known literature values. All pKa values given in the present specification are values determined by calculation using this software package.

Software package 1: Advanced Chemistry Development (ACD/Labs) Software V8.14 for Solaris (1994-2007 ACD/Labs)

Alternatively, pKa can also be determined by the molecular orbital method. One specific example of this method is to determine pKa by calculating H⁺ dissociation free energy in an aqueous solution on the basis of a thermodynamic cycle. The H⁺ dissociation free energy can be calculated by, for example, the density functional theory (DFT). However, this is not the only method, and various other methods have been reported in literatures, etc. There are multiple software programs capable of implementing DFT, such as Gaussian16.

As described above, pKa in the present specification refers to a value determined using the software package 1 by calculation of the Hammett substituent constant and values based on a database of known literature values, but when pKa cannot be calculated by this method, a value obtained using Gaussian16 on the basis of the density functional theory (DFT) is employed.

As described above, pKa in the present specification refers to "pKa in an aqueous solution", but when pKa in an aqueous solution cannot be calculated, "pKa in a dimethylsulfoxide (DMSO) solution" is employed.

In the present specification, examples of halogen atoms include a fluorine atom, a chlorine atom, a bromine atom, and an iodine atom.

In the present specification, solid contents mean all components that can constitute a resist film, other than solvents and a compound represented by formula (1) described later. Even if the components are in the form of liquid, the components are calculated as solid contents.

In the present specification, for example, when it is described that "a composition A includes substantially only a component B", it means that the content of the component B is 95 mass% or more relative to the total mass of the composition A. In the present specification, for example, when it is described that "a composition A substantially does not include a component C", it means that the content of the component C is 5 mass% or less relative to the total mass of the composition A.

### Actinic Ray-Sensitive or Radiation-Sensitive Resin Composition

An actinic ray-sensitive or radiation-sensitive resin composition (a resist composition) according to the present invention contains a resin that becomes more polar under the action of acid, a photoacid generator, a compound Y that is at least one selected from the group consisting of a compound represented by formula (1) and a compound represented by formula (2) described later, and a metal atom.

In the resist composition according to the present invention, the mass ratio of the content of the compound Y to the content of the metal atom is 1.0 × 10 to 1.0 × 10⁹.

In the present specification, "the content of the compound Y" means the total content of the compound represented by formula (1) and the compound represented by formula (2) described later.

Although the detailed mechanism by which a resist composition that produces the advantageous effect of the present invention well is provided when the mass ratio of the content of the compound Y to the content of the metal atom is 1.0 × 10 to 1.0 × 10⁹ has yet to be elucidated, the present inventors presume that if the content of the metal atom is relatively excessive, when a resist pattern formed using the resist composition is used as a mask to perform etching treatment on a target layer located below the resist pattern, many defects derived from the metal atom occur in a pattern formed, whereas if the content of the compound Y is relatively excessive, the resin is likely to decompose during the storage of the resist composition, and defects are likely to occur in a resist pattern formed using the resist composition after the storage.

Therefore, the resist composition according to the present invention has high preservation stability and is characterized in that when etching treatment is performed using a resist pattern formed from the resist composition as a mask, defects are less likely to occur in a pattern formed. In the present specification, "the advantageous effect of the present invention" means at least one of the above effect of suppressing the occurrence of pattern defects or preservation stability.

### Components of Resist Composition

The resist composition according to the present invention at least contains a resin that becomes more polar under the action of acid (hereinafter also referred to as an "acid-decomposable resin (A)" or a "resin (A)"), a photoacid generator, a compound Y, and a metal atom.

As the components included in the resist composition, components included in a known resist composition with which a resist pattern can be formed by performing an exposure treatment and a development treatment using a developer can be used.

The resist composition may be a positive-type resist composition or a negative-type resist composition. The resist composition may be a resist composition for alkali development or a resist composition for organic-solvent development.

The resist composition may be a chemically amplified resist composition or a non-chemically amplified resist composition. The resist composition is typically a chemically amplified resist composition.

The exposure treatment preferably includes EUV exposure, KrF exposure, ArF exposure, or EB exposure, and is more preferably EUV exposure. That is, the resist composition is preferably used for EUV exposure, KrF exposure, ArF exposure, or EB exposure, more preferably used for EUV exposure.

Hereinafter, various components included in the resist composition will be described in detail.

### Acid-Decomposable Resin (A)

The resist composition includes an acid-decomposable resin (A).

The resin (A) often includes a group that decomposes under the action of acid to become more polar (hereinafter also referred to as an "acid-decomposable group"), preferably includes a repeating unit having an acid-decomposable group.

When the resin (A) includes an acid-decomposable group, in a resist pattern forming method performed using the resist composition, typically, a positive-type pattern is suitably formed by employing an alkali developer as a developer, and a negative-type pattern is suitably formed by employing an organic-based developer as a developer.

The repeating unit having an acid-decomposable group is preferably not only a repeating unit having an acid-decomposable group described below but also a repeating unit having an acid-decomposable group including an unsaturated bond.

### Repeating Unit (A-a) Having Acid-Decomposable Group

The resin (A) preferably has a repeating unit (A-a) having an acid-decomposable group (hereinafter also referred to as a "repeating unit (A-a)").

The acid-decomposable group is a group that decomposes under the action of acid to yield a polar group, and preferably has a structure in which the polar group is protected by a leaving group that leaves under the action of acid. That is, the resin (A) preferably has a repeating unit (A-a) having a group that decomposes under the action of acid to yield a polar group. A resin having the repeating unit (A-a) becomes more polar under the action of acid to be more soluble in alkali developers and less soluble in organic solvents.

The polar group is preferably an alkali-soluble group; examples include alcoholic hydroxyl groups and acidic groups such as a carboxyl group, phenolic hydroxyl groups, fluoroalcohol groups, a sulfonic group, a sulfonamide group, a sulfonylimide group, (alkylsulfonyl)(alkylcarbonyl)methylene groups, (alkylsulfonyl)(alkylcarbonyl)imide groups, bis(alkylcarbonyl)methylene groups, bis(alkylcarbonyl)imide groups, bis(alkylsulfonyl)methylene groups, bis(alkylsulfonyl)imide groups, tris(alkylcarbonyl)methylene groups, and tris(alkylsulfonyl)methylene groups.

In particular, the polar group is more preferably a carboxyl group, a phenolic hydroxyl group, a fluoroalcohol group (preferably a hexafluoroisopropanol group), or a sulfonic group.

Examples of the leaving group that leaves under the action of acid include groups represented by formulae (Y1) to (Y4).

Formula (Y1): -C(Rx₁)(Rx₂)(Rx₃)

Formula (Y2): -C(=O)OC(Rx₁)(Rx₂)(Rx₃)

Formula (Y3): -C(R₃₆)(R₃₇)(OR₃₈)

Formula (Y4): -C(Rn)(H)(Ar)

In formula (Y1) and formula (Y2), Rx₁ to Rx₃ each independently represent an alkyl group (linear or branched), a cycloalkyl group (monocyclic or polycyclic), an alkenyl group (linear or branched), or an aryl group (monocyclic or polycyclic). When Rx₁ to Rx₃ are all alkyl groups (linear or branched), at least two of Rx₁ to Rx₃ are preferably methyl groups.

In particular, Rx₁ to Rx₃ preferably each independently represent a linear or branched alkyl group, and Rx₁ to Rx₃ more preferably each independently represent a linear alkyl group.

Two of Rx₁ to Rx₃ may be bonded to each other to form a monocyclic or polycyclic ring.

The alkyl group represented by Rx₁ to Rx₃ is preferably an alkyl group having 1 to 5 carbon atoms, such as a methyl group, an ethyl group, a n-propyl group, an isopropyl group, a n-butyl group, an isobutyl group, or a t-butyl group.

The cycloalkyl group represented by Rx₁ to Rx₃ is preferably a monocyclic cycloalkyl group such as a cyclopentyl group, or a cyclohexyl group or a polycyclic cycloalkyl group such as a norbornyl group, a tetracyclodecanyl group, a tetracyclododecanyl group, or an adamantyl group.

The aryl group represented by Rx₁ to Rx₃ is preferably an aryl group having 6 to 10 carbon atoms; examples include a phenyl group, a naphthyl group, and an anthryl group.

The alkenyl group represented by Rx₁ to Rx₃ is preferably a vinyl group.

The ring formed through the bonding of two of Rx₁ to Rx₃ is preferably a cycloalkyl group. The cycloalkyl group formed through the bonding of two of Rx₁ to Rx₃ is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group, more preferably a monocyclic cycloalkyl group having 5 or 6 carbon atoms.

In the cycloalkyl group formed through the bonding of two of Rx₁ to Rx₃, for example, one of methylene groups forming the ring may be replaced by a heteroatom such as an oxygen atom, a group having a heteroatom, such as a carbonyl group, or a vinylidene group. In the cycloalkyl group, one or more ethylene groups forming the cycloalkane ring may be replaced by vinylene groups.

The group represented by formula (Y1) or formula (Y2) preferably has a form, for example, in which Rx₁ is a methyl group or an ethyl group and Rx₂ and Rx₃ are bonded to each other to form the cycloalkyl group.

When the resist composition is, for example, a resist composition for EUV exposure, the alkyl group, the cycloalkyl group, the alkenyl group, and the aryl group represented by Rx₁ to Rx₃ and the ring formed through the bonding of two of Rx₁ to Rx₃ also preferably further have a fluorine atom or an iodine atom as a substituent.

In formula (Y3), R₃₆ to R₃₈ each independently represent a hydrogen atom or a monovalent organic group. R₃₇ and R₃₈ may be bonded to each other to form a ring. The monovalent organic group is, for example, an alkyl group, a cycloalkyl group, an aryl group, an aralkyl group, or an alkenyl group. R₃₆ is also preferably a hydrogen atom.

In the alkyl group, the cycloalkyl group, the aryl group, and the aralkyl group, a heteroatom such as an oxygen atom and/or a group having a heteroatom, such as a carbonyl group, may be included. For example, in the alkyl group, the cycloalkyl group, the aryl group, and the aralkyl group, for example, one or more methylene groups may each be replaced by a heteroatom such as an oxygen atom and/or a group having a heteroatom, such as a carbonyl group.

In the repeating unit having an acid-decomposable group described later, R₃₈ and another substituent on the main chain of the repeating unit may be bonded to each other to form a ring. The group formed through the bonding of R₃₈ and another substituent on the main chain of the repeating unit to each other is preferably an alkylene group such as a methylene group.

When the resist composition is, for example, a resist composition for EUV exposure, the monovalent organic groups represented by R₃₆ to R₃₈ and the ring formed through the bonding of R₃₇ and R₃₈ to each other also preferably further have a fluorine atom or an iodine atom as a substituent.

Formula (Y3) is preferably a group represented by formula (Y3-1) below.

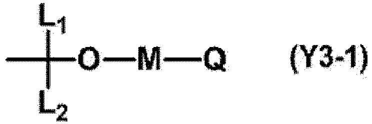

L₁ and L₂ each independently represent a hydrogen atom, an alkyl group, a cycloalkyl group, an aryl group, or a combination thereof (e.g., a combination of an alkyl group and an aryl group).

M represents a single bond or a divalent linking group.

Q represents an alkyl group that optionally includes a heteroatom, a cycloalkyl group that optionally includes a heteroatom, an aryl group that optionally includes a heteroatom, an amino group, an ammonium group, a mercapto group, a cyano group, an aldehyde group, or a combination thereof (e.g., a combination of an alkyl group and a cycloalkyl group).

In the alkyl group and the cycloalkyl group, for example, one methylene group may be replaced by a heteroatom such as an oxygen atom or a group having a heteroatom, such as a carbonyl group.

Preferably, one of L₁ and L₂ is a hydrogen atom, and the other is an alkyl group, a cycloalkyl group, an aryl group, or a combination of an alkylene group and an aryl group.

At least two of Q, M, and L₁ may be bonded to each other to form a ring (preferably, a five-membered or six-membered ring).

From the viewpoint of forming a finer pattern, L₂ is preferably a secondary or tertiary alkyl group, more preferably a tertiary alkyl group. The secondary alkyl group is, for example, an isopropyl group, a cyclohexyl group, or a norbornyl group, and the tertiary alkyl group is, for example, a tert-butyl group or an adamantane group. In the case of such a form, the repeating unit having an acid-decomposable group described later increases the glass transition temperature (Tg) and activation energy of the resin (A), so that film hardness can be ensured, and in addition fogging can be suppressed.

When the resist composition is, for example, a resist composition for EUV exposure, the alkyl group, the cycloalkyl group, the aryl group, and the combination thereof represented by L₁ and L₂ also preferably further have a fluorine atom or an iodine atom as a substituent. The alkyl group, the cycloalkyl group, the aryl group, and the aralkyl group also preferably include, in addition to the fluorine atom or the iodine atom, a heteroatom such as an oxygen atom (i.e., in the alkyl group, the cycloalkyl group, the aryl group, and the aralkyl group, for example, one methylene group is replaced by a heteroatom such as an oxygen atom or a group having a heteroatom, such as a carbonyl group).

When the resist composition is, for example, a resist composition for EUV exposure, in the alkyl group that optionally includes a heteroatom, the cycloalkyl group that optionally includes a heteroatom, the aryl group that optionally includes a heteroatom, the amino group, the ammonium group, the mercapto group, the cyano group, the aldehyde group, or the combination thereof represented by Q, the heteroatom is also preferably a heteroatom selected from the group consisting of a fluorine atom, an iodine atom, and an oxygen atom.

In formula (Y4), Ar represents an aromatic ring group. Rn represents an alkyl group, a cycloalkyl group, or an aryl group. Rn and Ar may be bonded to each other to form a non-aromatic ring. Ar is more preferably an aryl group.

When the resist composition is, for example, a resist composition for EUV exposure, the aromatic ring group represented by Ar and the alkyl group, the cycloalkyl group, or the aryl group represented by Rn also preferably have a fluorine atom and an iodine atom as substituents.

From the viewpoint of higher acid decomposability, when a non-aromatic ring is directly bonded to the polar group (or its residue) in the leaving group protecting the polar group, a ring-member atom in the non-aromatic ring adjacent to a ring-member atom directly bonded to the polar group (or its residue) also preferably does not have a halogen atom such as a fluorine atom as a substituent.

The leaving group that leaves under the action of acid may alternatively be a 2-cyclopentenyl group having a substituent (e.g., an alkyl group), such as a 3-methyl-2-cyclopentenyl group, or a cyclohexyl group having a substituent (e.g., an alkyl group), such as a 1,1,4,4-tetramethylcyclohexyl group.

The repeating unit (A-a) is also preferably a repeating unit represented by formula (A).

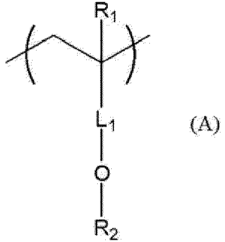

L₁ represents a divalent linking group that optionally has a fluorine atom or an iodine atom, R₁ represents an alkyl group that optionally has a hydrogen atom, a fluorine atom, an iodine atom, a fluorine atom, or an iodine atom or an aryl group that optionally has a fluorine atom or an iodine atom, and R₂ represents a leaving group that leaves under the action of acid and optionally has a fluorine atom or an iodine atom.

As a preferred form of the repeating unit represented by formula (A), at least one of L₁, R₁, or R₂ may have a fluorine atom or an iodine atom.

L₁ represents a divalent linking group that optionally has a fluorine atom or an iodine atom. Examples of the divalent linking group that optionally has a fluorine atom or an iodine atom include -CO-, -O-, -S-, -SO-, -SO₂-, a hydrocarbon group (e.g., an alkylene group, a cycloalkylene group, an alkenylene group, or an arylene group) that optionally has a fluorine atom or an iodine atom, and a linking group derived from linkage of two or more thereof. In particular, L₁ is preferably -CO-, an arylene group, or -arylene-alkylene that optionally has fluorine or iodine-, more preferably -CO-, an arylene group, or -arylene-alkylene that optionally has fluorine or iodine-.

The arylene group is preferably a phenylene group.

The alkylene group may be linear or branched. The number of carbon atoms of the alkylene group is not particularly limited, but is preferably 1 to 10, more preferably 1 to 3.

When the alkylene group has a fluorine atom or an iodine atom, the total number of fluorine atoms and iodine atoms included in the alkylene group is not particularly limited, but is preferably 2 or more, more preferably 2 to 10, still more preferably 3 to 6.

R₁ represents a hydrogen atom, a fluorine atom, an iodine atom, an alkyl group that optionally has a fluorine atom or an iodine atom, or an aryl group that optionally has a fluorine atom or an iodine atom.

The alkyl group may be linear or branched. The number of carbon atoms of the alkyl group is not particularly limited, but is preferably 1 to 10, more preferably 1 to 3.

The total number of fluorine atoms and iodine atoms included in the alkyl group having a fluorine atom or an iodine atom is not particularly limited, but is preferably 1 or more, more preferably 1 to 5, still more preferably 1 to 3.

The alkyl group may include a heteroatom other than halogen atoms, such as an oxygen atom.

R₂ represents a leaving group that leaves under the action of acid and optionally has a fluorine atom or an iodine atom. Examples of the leaving group that optionally has a fluorine atom or an iodine atom include the leaving groups represented by formulae (Y1) to (Y4) above and having a fluorine atom or an iodine atom, and preferred forms thereof are also the same.

The repeating unit (A-a) is also preferably a repeating unit represented by general formula (AI).

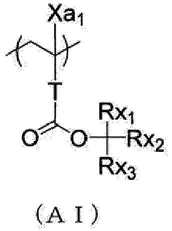

In general formula (AI),
Xa₁ represents a hydrogen atom or an optionally substituted alkyl group.
T represents a single bond or a divalent linking group.
Rx₁ to Rx₃ each independently represent an alkyl group (linear or branched), a cycloalkyl group (monocyclic or polycyclic), an aryl group, or an alkenyl group. When Rx₁ to Rx₃ are all alkyl groups (linear or branched), at least two of Rx₁ to Rx₃ are preferably methyl groups.
Two of Rx₁ to Rx₃ may be bonded to each other to form a cycloalkyl group (monocyclic or polycyclic).

The optionally substituted alkyl group represented by Xa₁ is, for example, a methyl group or a group represented as -CH₂-R₁₁. R₁₁ represents a halogen atom (e.g., a fluorine atom), a hydroxyl group, or a monovalent organic group, such as an alkyl group having 5 or less carbon atoms and optionally substituted with a halogen atom, an acyl group having 5 or less carbon atoms and optionally substituted with a halogen atom, or an alkoxy group having 5 or less carbon atoms and optionally substituted with a halogen atom, and is preferably an alkyl group having 3 or less carbon atoms, more preferably a methyl group. Xa₁ is preferably a hydrogen atom, a methyl group, a trifluoromethyl group, or a hydroxymethyl group.

Examples of the divalent linking group represented by T include alkylene groups, aromatic ring groups, -COO-Rt- groups, and -O-Rt- groups. In the formula, Rt represents an alkylene group or a cycloalkylene group.

T is preferably a single bond or -COO-Rt-. When T represents -COO-Rt-, Rt is preferably an alkylene group having 1 to 5 carbon atoms, more preferably -CH₂-, -(CH₂)₂-, or -(CH₂)₃-.

The alkyl group represented by Rx₁ to Rx₃ is preferably an alkyl group having 1 to 4 carbon atoms, such as a methyl group, an ethyl group, a n-propyl group, an isopropyl group, a n-butyl group, an isobutyl group, or a t-butyl group.

The cycloalkyl group represented by Rx₁ to Rx₃ is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group.

The cycloalkyl group formed through the bonding of two of Rx₁ to Rx₃ is preferably a monocyclic cycloalkyl group such as a cyclopentyl group or a cyclohexyl group, and is also preferably a polycyclic cycloalkyl group such as a norbornyl group, a tetracyclodecanyl group, a tetracyclododecanyl group, or an adamantyl group. In particular, a monocyclic cycloalkyl group having 5 or 6 carbon atoms is more preferred.

In the cycloalkyl group formed through the bonding of two of Rx₁ to Rx₃, for example, one methylene group forming the ring may be replaced by a heteroatom such as an oxygen atom or a group having a heteroatom, such as a carbonyl group.

The alkenyl group represented by Rx₁ to Rx₃ is, for example, a vinyl group.

The aryl group represented by Rx₁ to Rx₃ is, for example, a phenyl group.

The repeating unit represented by general formula (AI) preferably has a form, for example, in which Rx₁ is a methyl group or an ethyl group and Rx₂ and Rx₃ are bonded to each other to form the cycloalkyl group.

When the above-described groups each have a substituent, the substituent is, for example, an alkyl group (having 1 to 4 carbon atoms), a halogen atom, a hydroxyl group, an alkoxy group (having 1 to 4 carbon atoms), a carboxyl group, or an alkoxycarbonyl group (having 2 to 6 carbon atoms). The number of carbon atoms of the substituent is preferably 8 or less.

The repeating unit represented by general formula (AI) is preferably an acid-decomposable (meth)acrylic acid tertiary alkyl ester-based repeating unit (a repeating unit where Xa₁ represents a hydrogen atom or a methyl group and T represents a single bond).

The resin (A) may have one single type of repeating unit (A-a) or two or more types of repeating units (A-a).

The content of the repeating unit (A-a) (in the case where two or more repeating units (A-a) are present, the total content thereof) is preferably 15 to 80 mol%, more preferably 20 to 70 mol%, relative to all the repeating units in the resin (A).

The resin (A) preferably has, as the repeating unit (A-a), at least one repeating unit selected from the group consisting of repeating units represented by general formulae (A-VIII) to (A-XII) below.

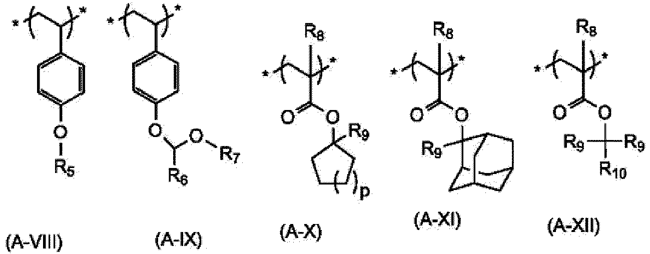

In general formula (A-VIII), R₅ represents a tert-butyl group or a -CO-O-(tert-butyl) group.

In general formula (A-IX), R₆ and R₇ each independently represent a monovalent organic group. The monovalent organic group is, for example, an alkyl group, a cycloalkyl group, an aryl group, an aralkyl group, or an alkenyl group.

In general formula (A-X), p represents 1 or 2.

In general formulae (A-X) to (A-XII), R₈ represents a hydrogen atom or an alkyl group having 1 to 3 carbon atoms, and R₉ represents an alkyl group having 1 to 3 carbon atoms.

In general formula (A-XII), R₁₀ represents an alkyl group having 1 to 3 carbon atoms or an adamantyl group.

### Repeating Unit (A-1) Having Acid Group

The resin (A) may have a repeating unit (A-1) having an acid group.

The acid group is preferably an acid group having a pKa of 13 or less. The acid dissociation constant of the acid group is preferably 13 or less, more preferably 3 to 13, still more preferably 5 to 10.

When the resin (A) has an acid group having a pKa of 13 or less, the content of the acid group in the resin (A) is not particularly limited but is often 0.2 to 6.0 mmol/g. In particular, the content of the acid group in the resin (A) is preferably 0.8 to 6.0 mmol/g, more preferably 1.2 to 5.0 mmol/g, still more preferably 1.6 to 4.0 mmol/g. When the content of the acid group is within this range, development proceeds well to form a pattern having a better shape and also having higher resolution.

The acid group is preferably, for example, a carboxyl group, a hydroxyl group, a phenolic hydroxyl group, a fluoroalcohol group (preferably a hexafluoroisopropanol group), a sulfonic group, a sulfonamide group, or an isopropanol group.

In the hexafluoroisopropanol group, one or more (preferably one or two) fluorine atoms may be substituted with groups other than fluorine atoms (e.g., alkoxycarbonyl groups). - C(CF₃)(OH)-CF₂- formed in this manner is also preferred as the acid group. One or more fluorine atoms may be substituted with groups other than fluorine atoms to form a ring including -C(CF₃)(OH)-CF₂-.

The repeating unit (A-1) having an acid group is preferably a repeating unit different from the above-described repeating unit having a structure in which a polar group is protected by a leaving group that leaves under the action of acid and a repeating unit (A-2) having a lactone group, a sultone group, or a carbonate group, which will be described later.

The repeating unit having an acid group may have a fluorine atom or an iodine atom.

In terms of higher sensitivity, the repeating unit having an acid group is preferably a repeating unit represented by formula (Y).

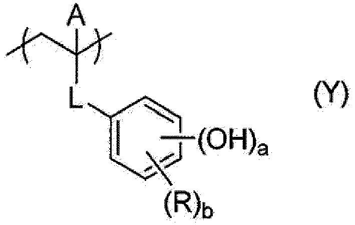

In formula (Y), A represents a hydrogen atom, an alkyl group, a cycloalkyl group, a halogen atom, or a cyano group.

L represents a single bond or a divalent linking group having an oxygen atom. L is preferably a single bond.

R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group. When a plurality of R's are present, they may be the same or different. When a plurality of R's are present, they may be bonded to each other to form a ring. R is preferably a hydrogen atom.
a represents an integer of 1 to 3.
b represents an integer of 0 to (5 - a).

Examples of the repeating unit having an acid group will be given below. In the formulae, a represents 1 or 2.

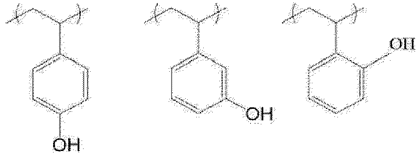

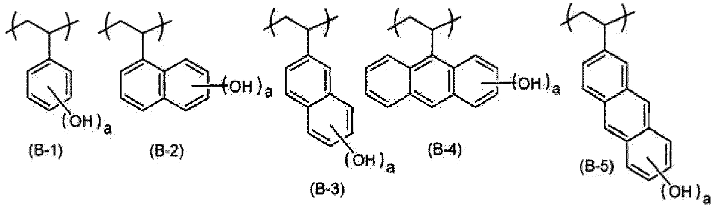

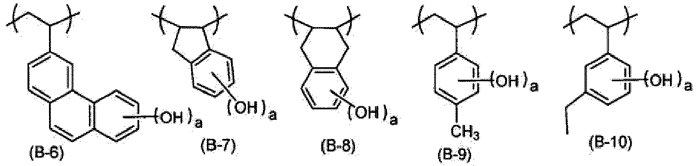

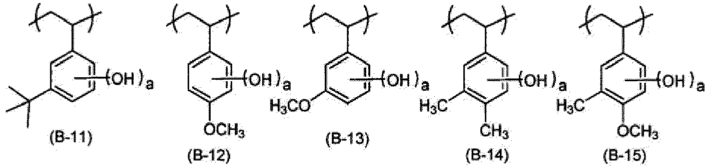

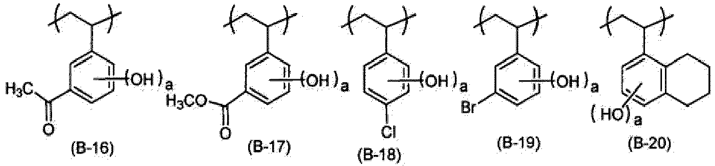

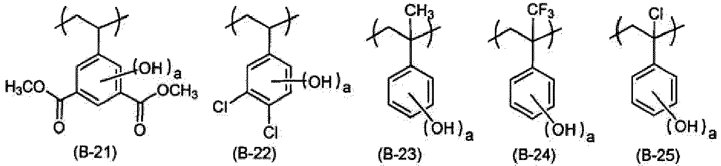

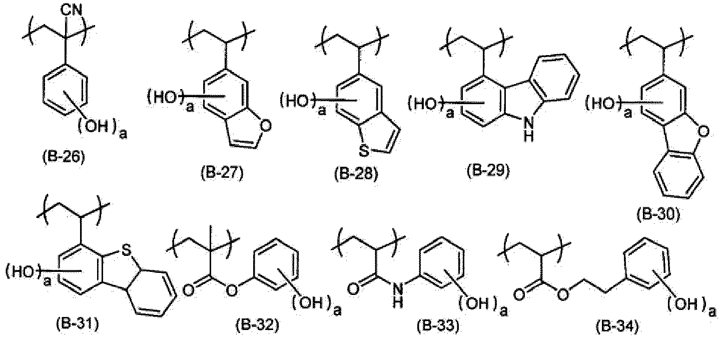

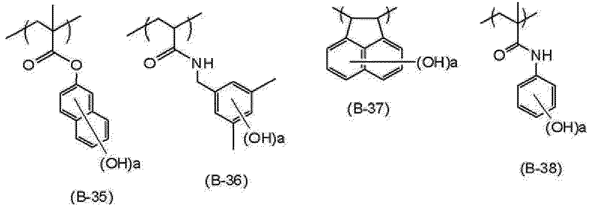

As the repeating unit having an acid group, for example, a repeating unit having a phenolic hydroxyl group described in paragraphs 0089 to 0100 of JP2018-189758A is also suitable for use.

When the resin (A) includes the repeating unit (A-1) having an acid group, a resist composition including this resin (A) is preferred for KrF exposure, EB exposure, or EUV exposure. In the case of such a form, the content of the repeating unit having an acid group in the resin (A) is preferably 30 to 100 mol%, more preferably 40 to 100 mol%, still more preferably 50 to 100 mol%, relative to all the repeating units in the resin (A).

### Repeating Unit (A-2) Having At Least One Selected from Group Consisting of Lactone Structure, Sultone Structure, Carbonate Structure, and Hydroxyadamantane Structure

The resin (A) may have a repeating unit (A-2) having at least one selected from the group consisting of a lactone structure, a carbonate structure, a sultone structure, and a hydroxyadamantane structure.

In a repeating unit having a lactone structure or a sultone structure, the lactone structure or the sultone structure is not particularly limited, but is preferably a five- to seven-membered lactone structure or a five- to seven-membered sultone structure, more preferably a five- to seven-membered lactone structure to which another ring structure is fused so as to form a bicyclo structure or a spiro structure or a five- to seven-membered sultone structure to which another ring structure is fused so as to form a bicyclo structure or a spiro structure.

Examples of the repeating unit having a lactone structure or a sultone structure include repeating units described in paragraphs 0094 to 0107 of WO2016/136354A.

The resin (A) may have a repeating unit having a carbonate structure. The carbonate structure is preferably a cyclic carbonate ester structure.

Examples of the repeating unit having a carbonate structure include repeating units described in paragraphs 0106 to 0108 of WO2019/054311A.

The resin (A) may have a repeating unit having a hydroxyadamantane structure. The repeating unit having a hydroxyadamantane structure is, for example, a repeating unit represented by general formula (AIIa) below.

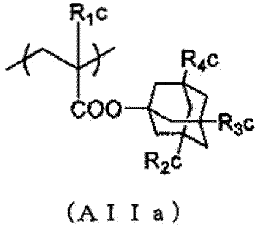

In general formula (AIIa), R₁c represents a hydrogen atom, a methyl group, a trifluoromethyl group, or a hydroxymethyl group. R₂c to R₄c each independently represent a hydrogen atom or a hydroxyl group. At least one of R₂c to R₄c represents a hydroxyl group. Preferably, one or two of R₂c to R₄c are hydroxyl groups, and the rest is a hydrogen atom.

### Repeating Unit Having Fluorine Atom or Iodine Atom

The resin (A) may have a repeating unit having a fluorine atom or an iodine atom.

Examples of the repeating unit having a fluorine atom or an iodine atom include repeating units described in paragraphs 0080 and 0081 of JP2019-045864A.

### Repeating Unit Having Photoacid Generating Group

The resin (A) may have, as a repeating unit other than the foregoing, a repeating unit having a group that generates an acid upon exposure to radiation.

Examples of the repeating unit having a fluorine atom or an iodine atom include repeating units described in paragraphs 0092 to 0096 of JP2019-045864A.

### Repeating Unit Having Alkali-Soluble Group

The resin (A) may have a repeating unit having an alkali-soluble group.

The alkali-soluble group is, for example, a carboxyl group, a sulfonamide group, a sulfonylimide group, a bissulfonylimide group, or an aliphatic alcohol substituted with an electron-withdrawing group at the α-position (e.g., a hexafluoroisopropanol group), preferably a carboxyl group. When the resin (A) has a repeating unit having an alkali-soluble group, higher resolution is provided in contact hole applications.

The repeating unit having an alkali-soluble group is, for example, a repeating unit in which an alkali-soluble group is directly bonded to the main chain of a resin, such as a repeating unit derived from acrylic acid or methacrylic acid, or a repeating unit in which an alkali-soluble group is bonded to the main chain of a resin through a linking group. The linking group may have a monocyclic or polycyclic hydrocarbon structure.

The repeating unit having an alkali-soluble group is preferably a repeating unit derived from acrylic acid or methacrylic acid.

### Repeating Unit Having Neither Acid-Decomposable Group nor Polar Group

The resin (A) may further have a repeating unit having neither an acid-decomposable group nor a polar group. The repeating unit having neither an acid-decomposable group nor a polar group preferably has an alicyclic hydrocarbon structure.

Examples of the repeating unit having neither an acid-decomposable group nor a polar group include repeating units described in paragraphs 0236 and 0237 of US2016/0026083A and repeating units described in paragraph 0433 of US2016/0070167A.

The resin (A) may have, in addition to the foregoing repeating structural units, various repeating structural units for the purpose of adjusting, for example, dry etching resistance, standard developer suitability, substrate adhesiveness, resist profile, resolving power, heat resistance, and sensitivity.

### Properties of Resin (A)

In the resin (A), all the repeating units are preferably constituted by repeating units derived from (meth)acrylate monomers. In this case, any of resins in which all the repeating units are derived from methacrylate monomers, resins in which all the repeating units are derived from acrylate monomers, and resins in which all the repeating units are derived from methacrylate monomers and acrylate monomers can be used. The content of repeating units derived from acrylate monomers is preferably 50 mol% or less relative to all the repeating units in the resin (A).

When the resist composition is used for argon fluoride (ArF) exposure, the resin (A) preferably has substantially no aromatic groups from the viewpoint of ArF light transmittance. More specifically, the content of repeating units having aromatic groups is preferably 5 mol% or less, more preferably 3 mol% or less, ideally 0 mol%, relative to all the repeating units in the resin (A). That is, the resin (A) still more preferably has no repeating units having aromatic groups.

When the resist composition is used for ArF exposure, the resin (A) preferably has a monocyclic or polycyclic alicyclic hydrocarbon structure and preferably includes neither a fluorine atom nor a silicon atom.

When the resist composition is used for krypton fluoride (KrF) exposure, EB exposure, or EUV exposure, the resin (A) preferably has a repeating unit having an aromatic hydrocarbon group, more preferably has a repeating unit having a phenolic hydroxyl group.

Examples of the repeating unit having a phenolic hydroxyl group include the foregoing repeating units given as examples of the repeating unit (A-1) having an acid group and repeating units derived from hydroxystyrene (meth)acrylate.

When the resist composition is used for KrF exposure, EB exposure, or EUV exposure, the resin (A) also preferably has a repeating unit having a structure in which a hydrogen atom of a phenolic hydroxyl group is protected by a group (leaving group) that decomposes and leaves under the action of acid.

When the resist composition is used for KrF exposure, EB exposure, or EUV exposure, the content of the repeating unit having an aromatic hydrocarbon group in the resin (A) is preferably 30 to 100 mol%, more preferably 40 to 100 mol%, still more preferably 50 to 100 mol%, relative to all the repeating units in the resin (A).

The resin (A) can be synthesized according to a conventional method (e.g., radical polymerization).

The weight-average molecular weight (Mw) of the resin (A) is preferably 1,000 to 200,000, more preferably 3,000 to 20,000, still more preferably 5,000 to 15,000. When the weight-average molecular weight (Mw) of the resin (A) is 1,000 to 200,000, decreases in heat resistance and dry etching resistance can be prevented, and furthermore a decrease in developability and a decrease in film formability due to an increase in viscosity can be prevented. The weight-average molecular weight (Mw) of the resin (A) is a polystyrene equivalent value determined by GPC described above.

The dispersity (molecular weight distribution) of the resin (A) is typically 1 to 5, preferably 1 to 3, more preferably 1.1 to 2.0. Smaller dispersities provide higher resolutions and better resist profiles, and further provide patterns with smoother side walls and higher roughness performance.

In the resist composition, the content of the resin (A) is preferably 50 to 99.9 mass%, more preferably 60 to 99.0 mass%, relative to the total solid contents of the resist composition.

One resin (A) may be used alone, or two or more resins (A) may be used in combination. Photoacid Generator (B)

The resist composition includes a photoacid generator (B). The photoacid generator (B) is not particularly limited as long as it is a compound that generates an acid upon exposure to radiation.

The photoacid generator (B) may be in the form of a low-molecular-weight compound or in the form of being incorporated into a part of a polymer. The form of a low-molecular-weight compound and the form of being incorporated into a part of a polymer may coexist.

When the photoacid generator (B) is in the form of a low-molecular-weight compound, its weight-average molecular weight (Mw) is preferably 3000 or less, more preferably 2000 or less, still more preferably 1000 or less.

When the photoacid generator (B) is in the form of being incorporated into a part of a polymer, it may be incorporated into a part of the resin (A) or incorporated into a resin different from the resin (A).

The photoacid generator (B) is preferably in the form of a low-molecular-weight compound.

The photoacid generator (B) is not particularly limited as long as it is a known photoacid generator, and is preferably a compound that generates an organic acid upon irradiation with radioactive rays, more preferably a photoacid generator having a fluorine atom or an iodine atom in its molecule.

Examples of the organic acid includes sulfonic acids (e.g., aliphatic sulfonic acids, aromatic sulfonic acids, and camphorsulfonic acid), carboxylic acids (e.g., aliphatic carboxylic acids, aromatic carboxylic acids, and aralkyl carboxylic acids), carbonylsulfonylimidic acid, bis(alkylsulfonyl)imidic acids, and tris(alkylsulfonyl)methide acids.

The volume of an acid generated from the photoacid generator (B) is not particularly limited, but from the viewpoint of suppressing the diffusion of the acid generated upon exposure to non-exposed portions to provide good resolution, it is preferably 240 Å³ or more, more preferably 305 Å³ or more, still more preferably 350 Å³ or more, particularly preferably 400 Å³ or more. From the viewpoint of sensitivity or solubility in applied solvent, the volume of an acid generated from the photoacid generator (B) is preferably 1500 Å³ or less, more preferably 1000 Å³ or less, still more preferably 700 Å³ or less.

The value of the volume is determined using "WinMOPAC" manufactured by Fujitsu Limited. In calculating the value of the volume, the chemical structure of each acid given as an example is first input; next, with this structure as an initial structure, the most stable conformation of each acid is determined by molecular force field calculation using Molecular Mechanics (MM) 3; and then molecular orbital calculation using Parameterized Model number (PM) 3 is performed on the most stable conformations, whereby the "accessible volume" of each acid can be calculated.

The structure of an acid generated from the photoacid generator (B) is not particularly limited, but from the viewpoint of suppressing the diffusion of the acid to provide good resolution, the interaction between the acid generated from the photoacid generator (B) and the resin (A) is preferably strong. From this viewpoint, when the acid generated from the photoacid generator (B) is an organic acid, the organic acid preferably further has a polar group in addition to organic acid groups such as a sulfonic group, a carboxylic group, a carbonylsulfonylimide acid group, a bissulfonylimide acid group, and a trissulfonylmethide acid group.

Examples of the polar group include an ether group, an ester group, an amide group, an acyl group, a sulfo group, a sulfonyloxy group, a sulfonamide group, a thioether group, a thioester group, a urea group, a carbonate group, a carbamate group, a hydroxyl group, and a mercapto group.

The number of polar groups of the acid generated is not particularly limited, preferably 1 or more, more preferably 2 or more. From the viewpoint of suppressing excessive development, the number of polar groups is preferably less than 6, more preferably less than 4.

In particular, the photoacid generator (B) is preferably a photoacid generator constituted by an anionic moiety and a cationic moiety.

Examples of the photoacid generator (B) include photoacid generators described in paragraphs 0144 to 0173 of JP2019-045864A.

The content of the photoacid generator (B) is not particularly limited, but is preferably 5 to 50 mass%, more preferably 5 to 40 mass%, still more preferably 5 to 35 mass%, relative to the total solid contents of the resist composition.

One photoacid generator (B) may be used alone, or two or more photoacid generators (B) may be used in combination. When two or more photoacid generators (B) are used in combination, their total content is preferably within the above range.

### Compound Y

The resist composition according to the present invention includes a compound Y that is at least one selected from the group consisting of a compound represented by formula (1) below and a compound represented by formula (2) below.

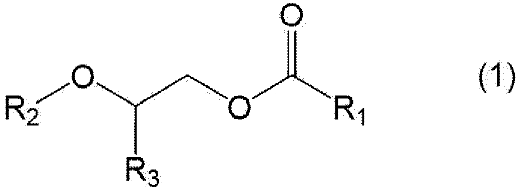

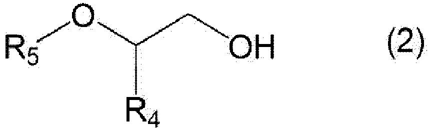

In formula (1), R₁ to R₃ each independently represent an alkyl group having 1 to 5 carbon atoms.

In formula (2), R₄ and R₅ each independently represent an alkyl group having 1 to 5 carbon atoms.

Each of the alkyl groups represented by R₁ to R₅ may be linear, branched, or cyclic, and is preferably linear.

In formula (1), the alkyl groups represented by R₁ to R₃ are each preferably a methyl group or an ethyl group, more preferably a methyl group.

The compound represented by formula (1) is, for example, 2-methoxypropyl acetate, 2-ethoxypropyl acetate, or 2-methoxypropyl propionate, preferably 2-methoxypropyl acetate.

In formula (2), the alkyl groups represented by R₄ and R₅ are each preferably a methyl group or an ethyl group, more preferably a methyl group.

The compound represented by formula (2) is, for example, 2-methoxy-1-propanol or 2-ethoxy-1-propanol, preferably 2-methoxy-1-propanol.

The compound Y is preferably 2-methoxypropyl acetate, 2-methoxy-1-propanol, 2-ethoxypropyl acetate, 2-ethoxy-1-propanol, or 2-methoxypropyl propionate, more preferably 2-methoxypropyl acetate or 2-methoxy-1-propanol.

The content of the compound Y is not particularly limited as long as its ratio to the content of the metal atom falls within a predetermined range, but for the advantageous effect of the present invention to be better produced, the content of the compound Y is preferably 200 mass ppm or less, more preferably 100 mass ppm or less, relative to the total mass of the resist composition. The lower limit is not particularly limited, but is preferably 0.1 mass ppm or more, more preferably 1 mass ppm or more, relative to the total mass of the resist composition.

In particular, when the resist composition contains propylene glycol methyl ether acetate (2-methoxy-1-methylethyl acetate) as a solvent (F) described later, the content of 2-methoxypropyl acetate is preferably 0.1 to 200 mass ppm, more preferably 1 to 100 mass ppm, relative to the total mass of the resist composition.

When the resist composition contains propylene glycol monomethyl ether (1-methoxy-2-propanol) as a solvent (F) described later, the content of 2-methoxy-1-propanol is preferably 0.1 to 200 mass ppm, more preferably 1 to 100 mass ppm, relative to the total mass of the resist composition.

The compound Y may be added into the resist composition or may be unintentionally incorporated into the resist composition during the process of producing of the resist composition. Examples of cases where the compound Y is unintentionally incorporated during the process of producing of the resist composition include, but are not limited to, the case where the compound Y is contained in a raw material (e.g., an organic solvent) used to produce the resist composition and the case where the compound Y is incorporated during the process of producing the resist composition.

The content of the compound Y included in the resist composition can be adjusted, for example, as follows: a plurality of raw materials used to produce the resist composition are provided, the content of the compound Y included in each raw material is measured in advance, and a mixed solution including the plurality of raw materials, the amount of each raw material being adjusted, is used; or the resist composition is produced under conditions where contamination is minimized by, for example, lining or coating the inside of an apparatus with a fluorocarbon resin or the like.

### Metal Atom

The resist composition according to the present invention contains a metal atom.

The "metal atom" contained in the resist composition in the present specification refers to Na, K, Ca, Fe, Cu, Mn, Mg, Al, Li, Cr, Ni, Sn, Ag, As, Au, Ba, Cd, Co, Mo, Zr, Pb, Ti, V, W, and Zn. These metal atoms are metal atoms that can be included in the resist composition during normal operation.

In the present specification, "the content of the metal atom" means the total content of the foregoing metals. The form of the metal atom contained in the resist composition is not particularly limited. The metal atom may be in the state of a compound such as a salt, an elemental metal, or an ion.

In the resist composition according to the present invention, the mass ratio of the content of the compound Y to the content of the metal atom (compound Y content/metal atom content) is 1.0 × 10 to 1.0 × 10⁹.

For the advantageous effect of the present invention to be better produced, the mass ratio of the content of the compound Y to the content of the metal atom is preferably 1.0 × 10 to 1.0 × 10⁹, more preferably 1.0 × 10² to 5.0 × 10⁸, still more preferably 1.0 × 10² to 1.0 × 10⁷.

For the advantageous effect of the present invention to be better produced, the content of the metal atom in the resist composition is preferably 0.1 to 10000 mass ppt, more preferably 1 to 1000 mass ppt, still more preferably 1 to 100 mass ppt, relative to the total mass of the resist composition.

The content of the metal atom in the resist composition and the resist film can be measured using, for example, inductively coupled plasma mass spectrometry (ICP-MS).

The metal atom may be added into the resist composition or may be unintentionally incorporated into the resist composition during the process of producing of the resist composition. Examples of cases where the metal atom is unintentionally incorporated during the process of producing of the resist composition include, but are not limited to, the case where the metal atom is contained in a raw material (e.g., an organic solvent) used to produce the resist composition and the case where the metal atom is incorporated during the process of producing the resist composition.

The content of the metal atom contained in the resist composition can also be reduced by a known method such as filtering the resist composition or a raw material such as an organic solvent through a filter, selecting a raw material with a low metal atom content, and distilling a raw material under conditions where contamination is suppressed by, for example, lining the inside of an apparatus with Teflon (registered trademark). The filter used to reduce the content of the metal atom and the method of the reduction, including preferred forms thereof, may be the same as those described in the method of removing metal impurities from various materials given later.

### Acid Diffusion Control Agent (C)

The resist composition may include an acid diffusion control agent (C).

The acid diffusion control agent (C) acts as a quencher that traps an acid generated from, for example, the photoacid generator (B) during exposure to suppress excessive acid generation that might cause the reaction of the acid-decomposable resin in unexposed portions. The acid diffusion control agent (C) may be, for example, a basic compound (CA), a basic compound (CB) that becomes less basic or loses its basicity upon exposure to radiation, an onium salt (CC) that makes a relatively weak acid compared to the photoacid generator (B), a low-molecular-weight compound (CD) having a nitrogen atom and having a group that leaves under the action of acid, or an onium salt compound (CE) having a nitrogen atom in a cationic moiety.

In the resist composition, a known acid diffusion control agent can be appropriately used. For example, known compounds disclosed in paragraphs [0627] to [0664] of US2016/0070167A, paragraphs [0095] to [0187] of US2015/0004544A, paragraphs [0403] to [0423] of US2016/0237190A, and paragraphs [0259] to [0328] of US2016/0274458A are suitable for use as the acid diffusion control agent (C).

Examples of the basic compound (CA) include repeating units described in paragraphs 0188 to 0208 of JP2019-045864A.

In the resist composition, the onium salt (CC) that makes a relatively weak acid compared to the photoacid generator (B) can be used as the acid diffusion control agent (C).

When the photoacid generator (B) and the onium salt that generates a relatively weak acid compared to the acid generated from the photoacid generator (B) are used as a mixture, the acid generated from the photoacid generator (B) upon exposure to actinic rays or radiation collide with the onium salt having an unreacted weak-acid anion to cause salt exchange, which results in the release of the weak acid and the formation of an onium salt having a strong-acid anion. Since the strong acid is exchanged with the weak acid having a lower catalytic ability in this process, the acid is apparently deactivated, so that acid diffusion can be controlled.

Examples of the onium salt that makes a relatively weak acid compared to the photoacid generator (B) include onium salts described in paragraphs 0226 to 0233 of JP2019-070676A.

When the acid diffusion control agent (C) is included in the resist composition, the content of the acid diffusion control agent (C) (in the case of a plurality of acid diffusion control agents (C), the total content thereof) is preferably 0.1 to 10.0 mass%, more preferably 0.1 to 5.0 mass%, relative to the total solid contents of the resist composition.

In the resist composition, one acid diffusion control agent (C) may be used alone, or two or more acid diffusion control agents (C) may be used in combination.

### Hydrophobic Resin (E)

The resist composition may include, as a hydrophobic resin (E), a hydrophobic resin different from the resin (A).

The hydrophobic resin (E) is preferably designed so as to be localized on the surface of the resist film, but unlike surfactants, the hydrophobic resin (E) need not necessarily have, in its molecule, a hydrophilic group and need not contribute to homogeneously mixing a polar substance and a non-polar substance.

Adding the hydrophobic resin (E) has advantages such as control of static and dynamic contact angles at the surface of the resist film with respect to water and suppression of outgassing.

From the viewpoint of localization in the surface layer of the film, the hydrophobic resin (E) preferably has one or more, more preferably has two or more, of a fluorine atom, a silicon atom, and a CH₃ partial structure included in a side chain moiety of the resin. The hydrophobic resin (E) preferably has a hydrocarbon group having 5 or more carbon atoms. Such a group may be present in the main chain of the resin or may be present as a substituent in a side chain of the resin.

When the hydrophobic resin (E) includes a fluorine atom and/or a silicon atom, the fluorine atom and/or the silicon atom in the hydrophobic resin may be included in the main chain or a side chain of the resin.

When the hydrophobic resin (E) has a fluorine atom, the partial structure having a fluorine atom is preferably an alkyl group having a fluorine atom, a cycloalkyl group having a fluorine atom, or an aryl group having a fluorine atom.

The alkyl group having a fluorine atom (preferably having 1 to 10 carbon atoms, more preferably having 1 to 4 carbon atoms) is a linear or branched alkyl group in which at least one hydrogen atom is substituted with a fluorine atom, and may further have a substituent other than the fluorine atom.

The cycloalkyl group having a fluorine atom is a monocyclic or polycyclic cycloalkyl group in which at least one hydrogen atom is substituted with a fluorine atom, and may further have a substituent other than the fluorine atom.

The aryl group having a fluorine atom is, for example, a group derived by substituting at least one hydrogen atom of an aryl group such as a phenyl group or a naphthyl group with a fluorine atom, and may further have a substituent other than the fluorine atom.

Examples of the repeating unit having a fluorine atom or a silicon atom include those given as examples in paragraph 0519 of US2012/0251948A.

As described above, the hydrophobic resin (E) also preferably has a CH₃ partial structure in a side chain moiety.

Here, the CH₃ partial structure in a side chain moiety in the hydrophobic resin includes CH₃ moieties having an ethyl group, a propyl group, or the like.

On the other hand, methyl groups directly bonded to the main chain of the hydrophobic resin (E) (e.g., an α-methyl group of a repeating unit having a methacrylic acid structure) contributes little to the surface localization of the hydrophobic resin (E) under the influence of the main chain, and thus shall not be included in the CH₃ partial structure in the present invention.

For the hydrophobic resin (E), the description in paragraphs [0348] to [0415] of JP2014-010245A can be referred to, and the contents thereof are incorporated herein.

As the hydrophobic resin (E), resins described in JP2011-248019A, JP2010-175859A, and JP2012-032544A are also suitable for use.

When the resist composition includes the hydrophobic resin (E), the content of the hydrophobic resin (E) is preferably 0.01 to 20 mass%, more preferably 0.1 to 15 mass%, relative to the total solid contents of the resist composition.

### Solvent (F)

The resist composition may include a solvent (F). The compound Y shall not be included in the solvent (F).

When the resist composition is a radiation-sensitive resin composition for EUV exposure, the solvent (F) preferably includes at least one of (F1) a propylene glycol monoalkyl ether carboxylate or (F2) at least one selected from the group consisting of propylene glycol monoalkyl ethers, lactates, acetates, alkoxypropionates, chain ketones, cyclic ketones, lactones, and alkylene carbonates. The solvent in this case may further include a component other than the components (F1) and (F2).

Combined use of the solvent including at least one of the component (F1) or (F2) and the resin (A) described above is preferred because the coating properties of the resist composition improves and a pattern with a smaller number of development defects can be formed.

The component (F1) is, for example, a compound represented by formula (3) below.

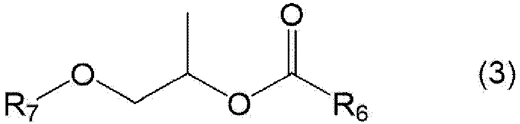

In formula (3), R₆ and R₇ each independently represent an alkyl group having 1 to 5 carbon atoms. The alkyl group represented by R₆ is preferably a methyl group or an ethyl group, more preferably a methyl group. The alkyl group represented by R₇ is preferably a methyl group or an ethyl group, more preferably a methyl group.

The component (F1) is preferably propylene glycol methyl ether acetate (2-methoxy-1-methylethyl acetate).

The propylene glycol monoalkyl ether included in the component (F2) is, for example, a compound represented by formula (4) below.

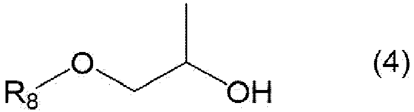

In formula (4), R₈ represents an alkyl group having 1 to 5 carbon atoms. The alkyl group represented by R₈ is preferably a methyl group or an ethyl group, more preferably a methyl group.

The compound represented by formula (4) above is preferably 1-methoxy-2-propanol.

The content of the component (F1) is preferably 20 to 99 mass%, more preferably 30 to 90 mass%, relative to the total content of the solvent (F).

The content of the component (F2) is preferably 5 to 90 mass%, more preferably 10 to 80 mass%, relative to the total content of the solvent (F).

When the resist composition is a radiation-sensitive resin composition for ArF, examples of the solvent (F) include organic solvents such as alkylene glycol monoalkyl ether carboxylates, alkylene glycol monoalkyl ethers, alkyl lactates, alkyl alkoxypropionates, cyclic lactones (preferably having 4 to 10 carbon atoms), monoketone compounds (preferably having 4 to 10 carbon atoms) optionally including a ring, alkylene carbonates, alkyl alkoxyacetates, and alkyl pyruvates.

The content of the solvent (F) in the resist composition is preferably determined such that the concentration of solid contents is 0.5 to 40 mass%.

In one embodiment of the resist composition, the concentration of solid contents is also preferably 10 mass% or more.

### Peroxide

When the solvent (F) has an oxygen-containing functional group, particularly when the solvent (F) is a solvent (F1), a peroxide may be formed in the resist composition. When the amount of peroxide included in the resist composition is excessive, other components are oxidized during storage of the resist composition, which may result in a decrease in quality of a resist film or resist pattern formed using the resist composition after storage.

From the above viewpoint, for the advantageous effect of the present invention to be better produced, the content of the peroxide in the resist composition is preferably 100 mass ppm or less, more preferably 10 mass ppm or less, relative to the total mass of the resist composition. The lower limit is not particularly limited and may be below the detection limit, and is preferably 3 mass ppm or more relative to the total mass of the resist composition.

Similarly, for the advantageous effect of the present invention to be better produced, the content of the peroxide in the solvent (F) is preferably 100 mass ppm or less, more preferably 10 mass ppm or less, relative to the total mass of the solvent (F). The lower limit is not particularly limited and may be below the detection limit, and is preferably 3 mass ppm or more relative to the total mass of the solvent (F).

The content of the peroxide in the resist composition and the solvent (F) can be quantitatively determined by a known method such as GC, HPLC, or NMR.

### Surfactant (H)

The resist composition may include a surfactant (H). The presence of the surfactant (H) enables formation of a pattern having higher adhesiveness and fewer development defects.

The surfactant (H) is preferably a fluorine-based and/or silicon-based surfactant.

Examples of the fluorine-based and/or silicon-based surfactant include surfactants described in paragraph [0276] of US2008/0248425A.

Instead of using a known surfactant as described above, the surfactant (H) may be synthesized using a fluoroaliphatic compound produced by telomerization (also referred to as a telomer method) or oligomerization (also referred to as an oligomer method). Specifically, a polymer including a fluoroaliphatic group derived from the fluoroaliphatic compound may be used as the surfactant (H). The fluoroaliphatic compound can be synthesized by, for example, a method described in JP2002-090991A.

These surfactants (H) may be used alone or in combination of two or more.

The content of the surfactant (H) is preferably 0.0001 to 2 mass%, more preferably 0.0005 to 1 mass%, relative to the total solid contents of the resist composition.

### Other Additives

The resist composition may further include a crosslinking agent, an alkali-soluble resin, a dissolution-inhibiting compound, a dye, a plasticizer, a photosensitizer, a light absorbent, and/or a compound that enhances solubility in a developer.

The content of the components (excluding metal atoms) included in the resist composition can be measured by a known method such as gas chromatography-mass spectrometry (GC-MS).

### Requirement 1

For the advantageous effect of the present invention to be better produced, the resist composition preferably satisfies requirement 1 below.

Requirement 1: the resist composition is applied to a surface of a silicon wafer having a diameter of 12 inches, and a resulting coating film is baked at 120°C for 60 seconds to prepare a silicon wafer having a resist film with a thickness of 50 nm; the silicon wafer having the resist film is immersed in a mixed solution which includes butyl acetate and undecane and in which the mass ratio of butyl acetate:undecane is 9:1 to remove the resist film from the silicon wafer; defects on the surface of the silicon wafer from which the resist film has been removed are then measured using a defect evaluation apparatus; and the number of measured defects per silicon wafer is 1 to 1000.

The above number of defects on the surface of the silicon wafer from which the resist film has been removed can be controlled by varying the method for producing the resist composition described later. More specifically, the number of defects can be controlled by varying, in the step of performing filtration using a filter, production conditions such as the type and pore size of the filter, the filtration pressure, the number of times of filtration, and the method of pre-washing the filter.

### Method for Producing Resist Composition

The method for producing the resist composition is not particularly limited. The method has, for example, a step of mixing various components such as an acid-decomposable resin and a photoacid generator, and preferably has a step of dissolving the components in a solvent and then filtering the solution through a filter.

In the filter filtration, it is preferable to use a plurality of filters made of different materials (cycle filtration may also be used). More specifically, the filtration is preferably performed with a polyethylene filter with a pore size of 50 nm, a nylon filter with a pore size of 10 nm, and a polyethylene filter with a pore size of 3 to 5 nm connected in series. It is also preferable to perform cycle filtration twice or more. The filtration step can also reduce the content of the metal atom in the resist composition. The pressure difference between the filters is preferably as small as possible, and is preferably 0.1 MPa or less, more preferably 0.05 MPa or less, still more preferably 0.01 MPa or less.

When cycle filtration is performed using a filter in the production of the resist composition, for example, it is also preferable to perform cycle filtration twice or more using a polytetrafluoroethylene filter with a pore size of 50 nm.

### Method for Producing Resist Pattern

The resist composition according to the present invention is used for resist pattern formation. One non-limiting example of a method of forming a resist film using the resist composition is a method having a step of forming a resist film on a substrate using the resist composition.

A method for producing a resist pattern according to the present invention has the following steps 1 to 3.
- Step 1: a resist film formation step of forming a resist film on a substrate using the resist composition.
- Step 2: an exposure step of exposing the resist film.
- Step 3: a development step of developing the exposed resist film using a developer to form a pattern.

The procedure of each step will be described in detail.

### Step 1: Resist Film Formation Step

The step 1 is a step of forming a resist film by applying the resist composition onto a substrate.

One example of a method of forming a resist film using the resist composition is application of the resist composition onto a substrate. The resist composition is as previously described.

The application of the resist composition onto a substrate is performed, for example, in such a manner that the resist composition is applied, using a device such as a spinner or a coater, onto a substrate (e.g., silicon) used to manufacture a semiconductor device such as an integrated circuit.

The method of the application is preferably spin coating using a spinner. The number of rotations in performing spin coating is preferably 1000 to 3000 rpm.

The substrate is not particularly limited as long as it is a substrate as used in manufacturing an integrated circuit element, and is, for example, a silicon wafer or a silicon wafer coated with silicon dioxide, preferably a silicon wafer.

The substrate coated with the resist composition may be dried to form a resist film. The method of the drying is, for example, heating. The heating may be performed using means provided in a known exposure device and/or a known development device and a hot plate.

The heating temperature is preferably 80°C to 150°C, more preferably 80°C to 140°C, still more preferably 80°C to 130°C. The heating time is preferably 30 to 1000 seconds, more preferably 30 to 800 seconds, still more preferably 40 to 600 seconds. The heating may be performed once or more than once.

To allow formation of a more accurate fine pattern, the thickness of the resist film is preferably 10 to 90 nm, more preferably 10 to 65 nm, still more preferably 15 to 50 nm.

An undercoat film (e.g., an inorganic film, an organic film, or an antireflection film) may be formed between the substrate and the resist film.

A resist composition for undercoat film formation preferably includes a known organic material or a known inorganic material.

The thickness of the undercoat film is preferably 10 to 90 nm, more preferably 10 to 50 nm, still more preferably 10 to 30 nm.

Examples of the resist composition for undercoat film formation include AL412 (manufactured by Brewer Science, Inc.) and SHB series (e.g., SHB-A940, manufactured by Shin-Etsu Chemical Co., Ltd.).

A topcoat may be formed using a topcoat resist composition on a surface of the resist film opposite to the substrate.

Preferably, the topcoat resist composition does not mix with the resist film and can be uniformly applied to the surface of the resist film opposite to the substrate.

The topcoat resist composition preferably includes a resin, an additive, and a solvent.

A method of forming the topcoat is, for example, a known topcoat forming method, specifically, a topcoat forming method described in paragraphs [0072] to [0082] of JP2014-059543A.

In the method of forming the topcoat, it is preferable to form a topcoat including a basic compound described in JP2013-061648A on the surface of the resist film opposite to the substrate. Examples of the basic compound include basic compounds described in WO2017/002737A.

The topcoat also preferably includes a compound having at least one selected from the group consisting of -O-, -S-, a hydroxy group, a thiol group, -CO-, and -COO-.

### Step 2: Exposure Step

The step 2 is a step of exposing the resist film formed in the step 1.

The step 2 is preferably a step of performing pattern exposure through a photomask.

The photomask may be, for example, a known photomask. The photomask may be in contact with the resist film.

Examples of exposure light for exposing the resist film include infrared light, visible light, ultraviolet light, far ultraviolet light, extreme ultraviolet light (EUV), X-rays, and electron beams.

The exposure light preferably has a wavelength of 250 nm or less, more preferably has a wavelength of 220 nm or less, and still more preferably has a wavelength of 1 to 200 nm. Specifically, the exposure light is preferably KrF excimer laser (wavelength: 248 nm), ArF excimer laser (wavelength: 193 nm), F₂ excimer laser (wavelength: 157 nm), X-rays, EUV (wavelength: 13 nm), or an electron beam, more preferably KrF excimer laser, ArF excimer laser, EUV, or an electron beam, still more preferably EUV or an electron beam.

The exposure dose can be appropriately adjusted according to the desired pattern shape.

The method of exposure in the exposure step may be liquid immersion exposure.

The exposure step may be performed once or more than once.

After the exposure step, post exposure bake (PEB) may be performed before the development step described later.

The heating temperature in the post exposure bake is preferably 80°C to 150°C, more preferably 80°C to 140°C, still more preferably 80°C to 130°C. The heating time is preferably 10 to 1000 seconds, more preferably 10 to 180 seconds, still more preferably 30 to 120 seconds.

The post exposure bake may be performed using means provided in a known exposure device and/or development device and a hot plate. The post exposure bake may be performed once or more than once.

### Step 3: Development Step

The step 3 is a step of developing the exposed resist film using a developer to form a pattern.

Examples of methods of the development include immersing the substrate in a tank filled with a developer for a certain period of time (dipping method), forming a puddle of a developer on the surface of the substrate by the action of surface tension and leaving them to stand for a certain period of time to achieve development (puddling method), spraying a developer onto the surface of the substrate (spraying method), and continuously ejecting a developer, while scanning a jetting nozzle at a constant rate, onto the substrate rotating at a constant rate (dynamic dispensing method), but are not limited thereto.

After the development step, a step of stopping the development while performing replacement with another solvent may be performed.

The developing time is not particularly limited as long as non-exposed portions or exposed portions to be dissolved are sufficiently dissolved, and is preferably 10 to 300 seconds, more preferably 20 to 120 seconds.

The temperature of the developer is preferably 0°C to 50°C, more preferably 15°C to 35°C.

### Developer

The developer is not particularly limited as long as it can dissolve a resist film formed using the resist composition, and a developer suitable for the resist composition can be appropriately selected from known developers.

The expression "a resist film formed using the resist composition" or just "a resist film" in the present specification includes both an unexposed film not subjected to an exposure treatment after being formed using the resist composition and a film subjected to an exposure treatment after being formed using the resist composition. That is, the developer may be a negative-type developer which forms a resist pattern by removing an unexposed portion of a resist film or a positive-type developer which forms a resist pattern by removing an exposed portion of a resist film.

The developer is, for example, an alkali developer or an organic solvent developer, preferably an organic solvent developer.

The alkali developer is preferably an alkaline aqueous solution including an alkali. The alkaline aqueous solution may be of any type and is, for example, an alkaline aqueous solution including at least one selected from the group consisting of quaternary ammonium salts typified by tetramethylammonium hydroxide, inorganic alkalis, primary amines, secondary amines, tertiary amines, alcohol amines, and cyclic amines. In particular, the alkali developer is preferably an aqueous solution of a quaternary ammonium salt typified by tetramethylammonium hydroxide (TMAH). An appropriate amount of an alcohol, a surfactant, or the like may be added to the alkali developer.

The alkali developer often has an alkali concentration of 0.1 to 20 mass%. The alkali developer often has a pH of 10.0 to 15.0.

The organic solvent developer is a developer including an organic solvent.

The vapor pressure of the organic solvent included in the organic solvent developer (in the case of a mixed solvent, the vapor pressure of the whole mixed solvent) at 20°C is preferably 5 kPa or less, more preferably 3 kPa or less, still more preferably 2 kPa or less. When the vapor pressure of the organic solvent is 5 kPa or less, evaporation of the developer on the substrate or in a development cup is suppressed, and the temperature uniformity in a wafer plane is improved, resulting in better dimensional uniformity in the wafer plane.

The organic solvent used in the organic solvent developer may be a known organic solvent, such as an ester solvent, a ketone solvent, an alcohol solvent, an amide solvent, an ether solvent, or a hydrocarbon solvent.

The ester solvent is, for example, an ester solvent having 3 to 12 carbon atoms, preferably an ester solvent having 4 to 10 carbon atoms, more preferably an ester solvent having 5 to 8 carbon atoms.

The ester solvent may have an alkyl group. The alkyl group may be linear, branched, or cyclic, and is preferably linear.

The heteroatom contained in the ester solvent is preferably an oxygen atom, and the heteroatom contained is more preferably the oxygen atom alone. The ester solvent may have one or more -COO- moieties, and preferably has only one -COO- moiety.

More specific examples of the ester solvent include methyl acetate, butyl acetate, ethyl acetate, isopropyl acetate, isobutyl acetate, t-butyl acetate, pentyl acetate (amyl acetate), isopentyl acetate (isoamyl acetate), propylene glycol monomethyl ether acetate, ethylene glycol monoethyl ether acetate, diethylene glycol monobutyl ether acetate, diethylene glycol monoethyl ether acetate, ethyl-3-ethoxy propionate, 3-methoxybutyl acetate, 3-methyl-3-methoxybutyl acetate, methyl formate, ethyl formate, butyl formate, propyl formate, amyl formate, isoamyl formate, ethyl lactate, butyl lactate, propyl lactate, propyl propionate, isopropyl propionate, butyl propionate, isobutyl propionate ethyl butyrate, propyl butyrate, isopropyl butyrate, butyl butanoate (butyl butyrate), methyl 2-hydroxyisobutyrate, ethyl isobutyrate, propyl isobutyrate, and isobutyl isobutyrate.

Of these, butyl acetate, isobutyl acetate, t-butyl acetate, amyl acetate, isoamyl acetate, amyl formate, isoamyl formate, propyl propionate, isopropyl propionate, butyl propionate, isobutyl propionate, ethyl butyrate, propyl butyrate, isopropyl butyrate, ethyl isobutyrate, and propyl isobutyrate are preferred, butyl acetate, isobutyl acetate, and isoamyl acetate are more preferred, and butyl acetate is still more preferred.

Examples of the ketone solvent include 1-octanone, 2-octanone, 1-nonanone, 2-nonanone, acetone, 2-heptanone (methyl amyl ketone), 4-heptanone, 1-hexanone, 2-hexanone, diisobutyl ketone, cyclohexanone, methylcyclohexanone, phenylacetone, methyl ethyl ketone, methyl isobutyl ketone, acetyl acetone, acetonylacetone, ionone, diacetonyl alcohol, acetyl carbinol, acetophenone, methyl naphthyl ketone, isophorone, and propylene carbonate.

The hydrocarbon solvent is, for example, an aliphatic hydrocarbon solvent or an aromatic hydrocarbon solvent. The number of carbon atoms of the hydrocarbon solvent is preferably 3 to 20, more preferably 8 to 12, still more preferably 9 to 11.

The aliphatic hydrocarbon solvent may be a saturated aliphatic hydrocarbon solvent or an unsaturated aliphatic hydrocarbon solvent, and is preferably a saturated aliphatic hydrocarbon solvent. The aliphatic hydrocarbon solvent may be linear, branched, or cyclic, and is preferably linear. The aromatic hydrocarbon solvent may be monocyclic or polycyclic.

The hydrocarbon solvent is preferably a saturated aliphatic hydrocarbon solvent, more preferably a saturated aliphatic hydrocarbon solvent in which the number of carbon atoms is as described above, still more preferably octane, nonane, decane, undecane, or dodecane, particularly preferably nonane, decane, or undecane.

As the alcohol solvent, the amide solvent, the ether solvent, and the hydrocarbon solvent, solvents disclosed in paragraphs [0715] to [0718] of US2016/0070167A, the contents of which are incorporated herein, can be used.

The developer is preferably an organic solvent developer, more preferably includes at least one selected from the group consisting of an ester solvent and a hydrocarbon solvent, and is still more preferably a mixed solvent including an ester solvent and a hydrocarbon solvent.

In particular, the ester solvent is preferably any of the above preferred ester solvents, more preferably butyl acetate. That is, the developer particularly preferably includes any of the above preferred ester solvents (more preferably butyl acetate) and a hydrocarbon solvent.

It is also more preferred that the developer contain a plurality of the above preferred ester solvents, and it is more preferred that the developer contain a plurality of the above preferred ester solvents and contain at least one hydrocarbon solvent. When a plurality of the preferred ester solvents are contained, it is particularly preferred that one of the ester solvents be butyl acetate.

The hydrocarbon solvent used in combination with the ester solvent is, for example, any of the above preferred saturated aliphatic hydrocarbon solvents in terms of adjustment of the solubility of the resist film, preferably nonane, decane, or undecane, more preferably undecane.

The developer may include one of the above organic solvents alone or a combination of two or more thereof. When the developer includes two or more organic solvents, the content of each organic solvent is not particularly limited and may be appropriately determined because it depends on the solvent solubility of the resist film.

When the developer includes an ester solvent and a hydrocarbon solvent, the content of the ester solvent is preferably 10 to 95 mass%, more preferably 25 to 93 mass%, still more preferably 40 to 91 mass%, relative to the total mass of the developer. The content of the hydrocarbon solvent is preferably 5 to 90 mass%, more preferably 7 to 75 mass%, still more preferably 9 to 60 mass%, relative to the total mass of the developer. The developer particularly preferably includes the ester solvent and the hydrocarbon solvent alone in the above content ranges.

The content of the organic solvent (in the case of a mixture of a plurality of kinds, the total content) in the developer is preferably 80 mass% or more, more preferably 90 mass% or more, relative to the total mass of the developer. In particular, the developer still more preferably includes substantially only the organic solvent, and the content of the organic solvent is particularly preferably 98 mass% or more relative to the total mass of the developer. The upper limit is not particularly limited and may be 100 mass%.

The developer may include water but preferably includes substantially no water. The content of water is more preferably 2 mass% or less relative to the total mass of the developer, and the developer still more preferably includes no water.

### Other Steps

The pattern forming method preferably includes, after the step 3, a step of performing washing using a rinsing liquid.

The rinsing liquid for use in the rinsing step after the development step using a developer is, for example, pure water. An appropriate amount of surfactant may be added to the pure water.

An appropriate amount of surfactant may be added to the rinsing liquid.

The resist pattern formed in the step 3 described above is used as a mask when etching treatment is performed on a target layer below the resist pattern to process the target layer and form a pattern.

Examples of the target layer include a bulk layer and a silicon oxide layer. The pattern formed in the target layer functions as, for example, a part (e.g., a metal wiring line or a barrier layer) of a circuit board.

The method of processing the target layer is not particularly limited, but a preferred method is to perform dry etching on the target layer using the resist pattern formed in the step 3 as a mask, thereby forming a pattern in the target layer.

The dry etching may be single-step etching or multi-step etching. When the etching is performed in multiple steps, the etching treatment in each step may be the same or different. As an etching gas, for example, a gas mixture of a fluorocarbon gas such as CF₄, C₂F₈, CHF₃, CH₃F, or CH₂F₂ and Ar gas or a gas mixture of HBr and CO₂ can be used.

The etching can be performed by any known method, and various conditions and the like are appropriately determined depending on, for example, the type or intended use of the target layer. For example, the etching can be performed in accordance with, for example, Proceedings of International Society for Optics and Photonics (Proc. of SPIE), Vol. 6924, 692420 (2008) and JP2009-267112A. The etching can also be performed in accordance with a method described in "Chapter 4, Etching" of "Semiconductor Process Textbook, 4th edition, issued in 2007, publisher: SEMI Japan".

In particular, the dry etching is preferably oxygen plasma etching.

Various materials used in the method for producing a resist pattern and the above method for producing a pattern using the resist pattern (e.g., solvents, developers, rinsing liquids, compositions for antireflection film formation, and compositions for topcoat formation) are preferably free of impurities such as metal. The content of impurities included in these materials is preferably 1 mass ppm or less, more preferably 10 mass ppb or less, still more preferably 100 mass ppt or less, particularly preferably 10 mass ppt or less, most preferably 1 mass ppt or less. Examples of metal impurities include Na, K, Ca, Fe, Cu, Mn, Mg, Al, Li, Cr, Ni, Sn, Ag, As, Au, Ba, Cd, Co, Mo, Zr, Pb, Ti, V, W, and Zn.

An example of a method of removing impurities such as metal from the various materials is filtration using a filter. The pore size of the filter is preferably 0.20 µm or less, more preferably 0.05 µm or less, still more preferably 0.01 µm or less.

The material of the filter is preferably a fluorocarbon resin such as polytetrafluoroethylene (PTFE) or perfluoroalkoxyalkane (PFA), a polyolefin resin such as polypropylene or polyethylene, or a polyamide resin such as nylon 6 or nylon 66. The filter for use may be washed in advance with an organic solvent. In the filter filtration step, a plurality of filters or a plurality of types of filters may be used while being connected in series or in parallel. When a plurality of types of filters are used, filters having different pore sizes and/or made of different materials may be used in combination. The various materials may be filtered more than once, and the step of performing filtration more than once may be a cycle filtration step. The cycle filtration step is preferably performed by, for example, a method as disclosed in JP2002-062667A.

The filter is preferably a filter as disclosed in JP2016-201426A from which substances leach out in fewer amounts.

Instead of filter filtration, an adsorbent may be used to remove impurities, or filter filtration and an adsorbent may be used in combination. The adsorbent may be a known adsorbent, and, for example, an inorganic adsorbent such as silica gel or zeolite or an organic adsorbent such as activated carbon can be used. Examples of metal absorbents include those disclosed in JP2016-206500A.

Examples of methods of reducing the amount of impurities such as metal included in the various materials include selecting raw materials with low metal contents as raw materials constituting the various materials, performing filter filtration on raw materials constituting the various materials, and performing distillation under conditions where contamination is minimized by, for example, lining or coating the inside of an apparatus with a fluorocarbon resin or the like. Preferred conditions for the filter filtration performed on the raw materials constituting the various materials are the same as the conditions described above.

To prevent contamination by impurities, the various materials are preferably stored in containers described in, for example, US2015/0227049A, JP2015-123351A, and JP2017-013804A.

The various materials may be diluted, before use, with a solvent used in the resist composition.

### Electronic Device

The resist film and the resist pattern formed using the resist composition may be used to produce an electronic device.

Examples of the electronic device include, but are not limited to, electronic devices mounted on electric or electronic equipment (e.g., household appliances, office automation (OA), media-related equipment, optical equipment, and communication equipment).

### EXAMPLES

The present invention will now be described in more detail with reference to Examples. The materials, amounts, proportions, treatments, treatment sequences, etc. given in the following Examples may be changed as appropriate without departing from the spirit of the present invention. Thus, the scope of the present invention should not be construed as being limited by the Examples given below.

### Components of Resist Composition

The following components were used to prepare a resist composition. The components and raw materials for synthesizing the components were selected from high purity grade products for semiconductor manufacturing or compounds equivalent thereto.

### Synthesis of Resin (A)

In Examples and Comparative Examples, resins A-1 to A-6 below were used as the resin (A). Resins A-1 to A-6 used were each synthesized on the basis of a known technique.

Table 1 shows the compositional ratio of repeating units in the resin (A) (molar ratio; corresponding one-to-one from left to right), weight-average molecular weight (Mw), and dispersity (Mw/Mn).

**Table 1**

| Table 1 | Mass ratio of repeating units | | | | | Mw | Mw/Mn |
|---|---|---|---|---|---|---|---|
| Resin A-1 | 25.0 | 30.0 | 45.0 | - | - | 6143 | 1.58 |
| Resin A-2 | 40.0 | 10.0 | 50.0 | - | - | 7058 | 1.59 |
| Resin A-3 | 30.0 | 25.0 | 30.0 | 15.0 | - | 8123 | 1.64 |
| Resin A-4 | 35.0 | 35.0 | 30.0 | - | - | 7150 | 1.65 |
| Resin A-5 | 25.0 | 45.0 | 30.0 | - | - | 7520 | 1.78 |
| Resin A-6 | 35.0 | 25.0 | 34.0 | 3.0 | 3.0 | 4540 | 1.56 |

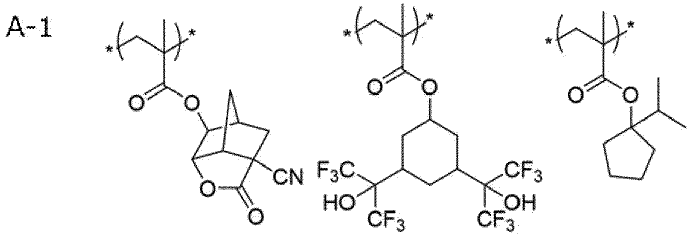

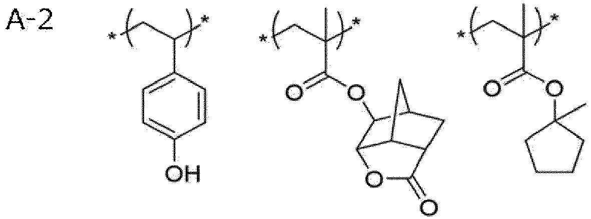

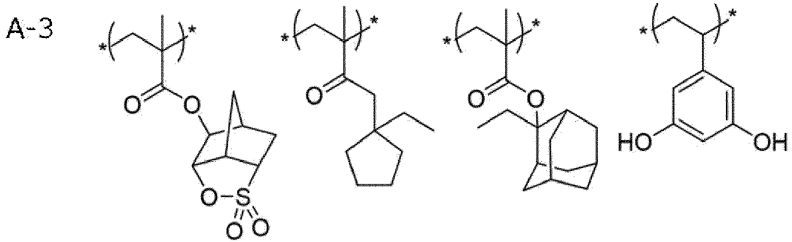

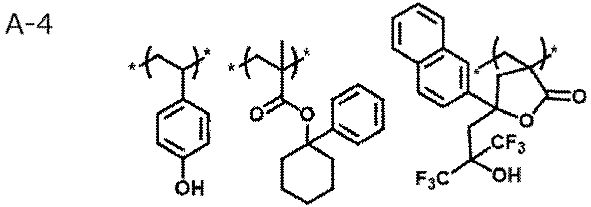

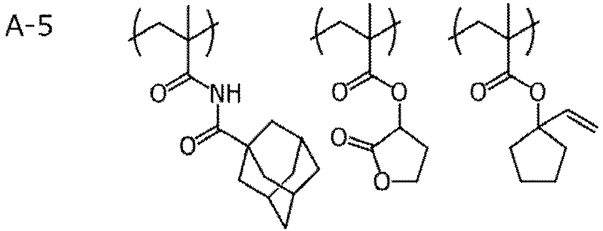

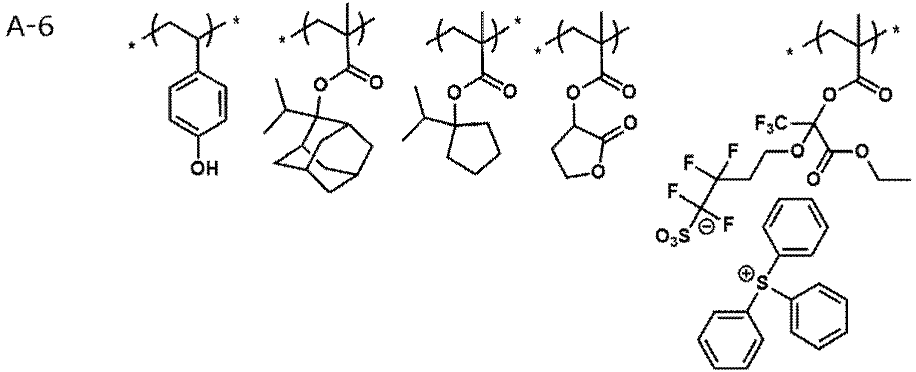

### Photoacid Generator (B)

The structures of compounds B-1 to B-6 used as the photoacid generator (B) in Examples and Comparative Examples are shown below.

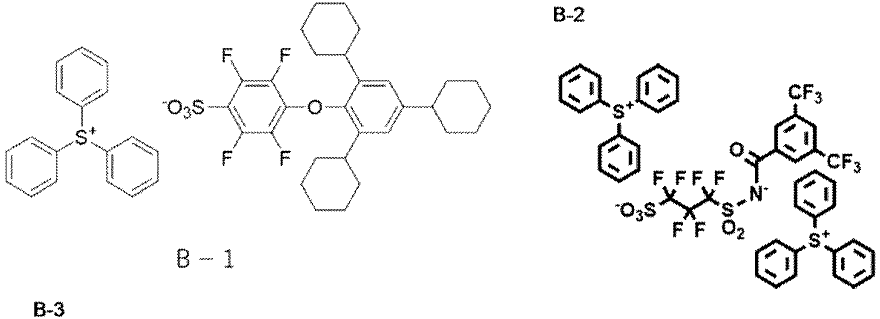

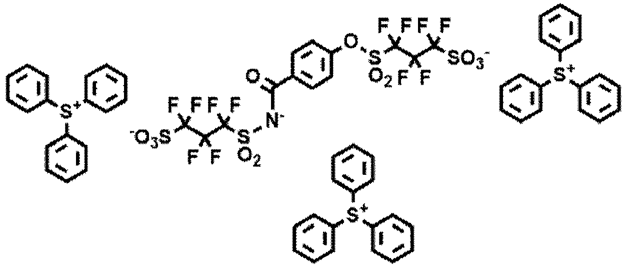

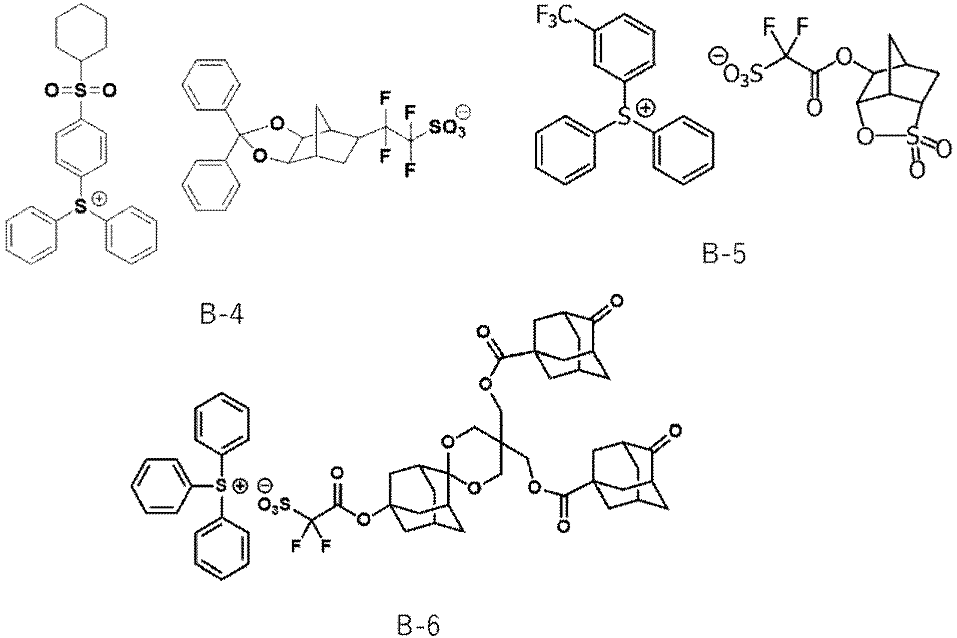

### Acid Diffusion Control Agent (C)

The structures of compounds C-1 to C-4 used as the acid diffusion control agent (C) in Examples and Comparative Examples are shown below.

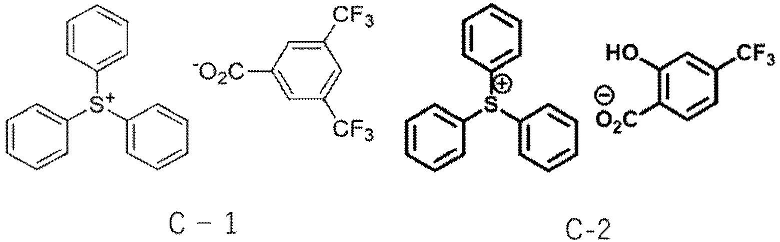

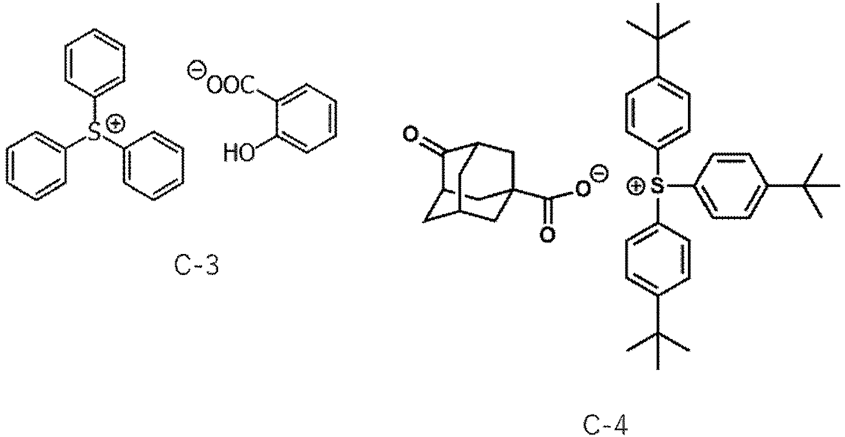

### Hydrophobic Resin (E)

In Examples and Comparative Examples, resin E-1 having the following structure was used as the hydrophobic resin (E). Resin E-1 used was synthesized on the basis of a known technique.

The compositional ratio (molar ratio) of the repeating units in resin E-1 was "85/10/5" from left to right. Resin E-1 had a weight-average molecular weight (Mw) of 11000 and a dispersity (Mw/Mn) of 1.55.

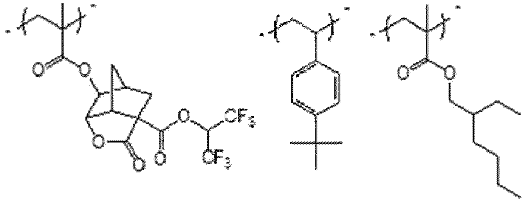

### Solvent (F)

In Examples and Comparative Examples, solvents F-1 to F-6 below were used as the solvent (F).
F-1: propylene glycol monomethyl ether acetate (PGMEA)
F-2: propylene glycol monomethyl ether (PGME)
F-3: γ-butyrolactone
F-4: ethyl lactate
F-5: cyclohexanone
F-6: 2-heptanone

### Compound Y

In Examples and Comparative Examples, 2-methoxypropyl acetate (compound Y1), 2-methoxy-1-propanol (compound Y2), 2-ethoxypropyl acetate (compound Y3), 2-ethoxy-1-propanol (compound Y4), and 2-methoxypropyl propionate (compound Y5) were used as the

### compound Y

### Preparation of Resist Composition

The resin (A), the photoacid generator (B), the acid diffusion control agent (C), the hydrophobic resin (E), and the solvent (F) were mixed so as to give a composition shown in Table 2 below. Next, the resulting mixed solution was filtered through, first, a polyethylene filter having a pore size of 50 nm, then, a nylon filter having a pore size of 10 nm, and, finally, a polyethylene filter having a pore size of 5 nm to prepare a composition.

The content of the metal atom was adjusted as shown in Table 2 by repeating a filtration treatment in which the composition prepared was allowed to pass through the filters or by adding a trace of metal or a metal-containing solution in which a trace of metal was dissolved or dispersed in the above solvents.

The contents of compounds Y1 and Y2 included in resist compositions Re-1 to Re-7 were adjusted as shown in Table 2 by using, as the solvent (F) in the preparation of the resist compositions, a mixed solution obtained by mixing two or more products different in lot, grade, or manufacturer, including compounds Y1 and Y2, and determined to be different in the content of compound Y1 or Y2 and/or adding a solution of compound Y1 and/or compound Y2 diluted with the above solvents to the solvent (F). In preparing resist compositions Re-1 to Re-4, Re-6, and Re-7, the content of the compound Y other than compound Y1 was adjusted to be considerably lower (at least two or three orders of magnitude lower) than the content of compound Y1. In preparing resist composition Re-5, the content of the compound Y other than compounds Y1 and Y2 was adjusted to be considerably lower (at least two or three orders of magnitude lower) than the content of compounds Y1 and Y2.

Similarly, the contents of compounds Y1 to Y5 included in resist compositions Re-8 to Re-15 were adjusted as shown in Table 2 by using, as the solvent (F) in the preparation of the resist compositions, a mixed solution obtained by mixing two or more products different in lot, grade, or manufacturer, including compounds Y1 to Y5, and determined to be different in the contents of compounds Y1 to Y5 and/or adding a solution of any of compounds Y1 to Y5 diluted with the above solvents to the solvent (F). For resist compositions Re-8 to Re-15, compounds whose contents (mass ppm) are shown to be "0" in Table 2 given later mean that their contents are considerably lower (at least two or three orders of magnitude lower) than the contents of compounds shown to be other than "0".

In the above manner, resist compositions Re-1 to Re-15, Re-C1, and Re-C2 shown in Table 2 were prepared.

In the following tables, the "Amount (%)" columns of components such as the resin (A), the photoacid generator (B), the acid diffusion control agent (C), and the hydrophobic resin (E) each mean a "content (mass%)" relative to the total solid contents.

The "Concentration of solid contents (%)" column means the total content (mass%) of components other than the solvent and the compound Y relative to the total mass of the resist composition.

The "Mixing ratio" column of "Solvent" represents the mass ratio of solvents.

The "Compound Y" column represents the content (mass ppm) of the compound Y (the total content of compounds Y1 to Y5) relative to the total mass of the resist composition. The "Compound Y1" to "Compound Y5" columns represent the contents (mass ppm) of compounds Y1 to Y5, respectively, relative to the total mass of the resist composition.

The "Metal X" column represents the content (mass ppm) of the metal atom relative to the total mass of the resist composition. The metal atoms detected in the resist composition were Na, K, Ca, Fe, Cu, Mn, Mg, Al, Li, Cr, Ni, Sn, Ag, As, Au, Ba, Cd, Co, Mo, Zr, Pb, Ti, V, W, and Zn.

The "Y/X" column represents the mass ratio of the total content (mass ppm) of the compound Y to the content (mass ppm) of the metal atom (compound Y content/metal atom content).

The "Peroxide" column represents the content (mass ppm) of the peroxide relative to the total mass of the resist composition.

In each column in the tables, "E+n" indicates "× 10ⁿ", and "E-n" indicates "× 10⁻ⁿ". n represents an integer of 0 or greater. Specifically, "1.00E-7" indicates "1.00 × 10⁻⁷", and "5.00E+8" indicates "5.00 × 10⁸".

The content of each component was calculated from a loading amount or measured using the above-described method of measuring the content of each component.

**Table 2**

| Table 2 (1) | Resin (A) | | Photoacid generator (B) | | Acid diffusion control agent (C) | | Hydrophobic resin (E) | | Concentration of solid contents (%) |
|---|---|---|---|---|---|---|---|---|---|
| | Type | Amount (%) | Type | Amount (%) | Type | Amount (%) | Type | Amount (%) | |
| Re-1 | A-1 | 84.0 | B-1 | 12.0 | C-1 | 4.0 | - | - | 2.0 |
| Re-2 | A-2 | 78.0 | B-2 | 22.0 | - | - | - | - | 2.0 |
| Re-3 | A-3 | 75.5 | B-3 | 16.0 | C-1 | 2.5 | E-1 | 6.0 | 2.0 |
| Re-4 | A-4 | 80.0 | B-4 | 14.0 | C-2 | 6.0 | - | - | 2.0 |
| Re-5 | A-5 | 78.0 | B-5 | 18.0 | C-3 | 4.0 | - | - | 2.0 |
| Re-6 | A-6 | 77.0 | B-6 | 20.0 | C-4 | 3.0 | - | - | 2.0 |
| Re-7 | A-1 | 76.0 | B-4 | 19.0 | C-3 | 5.0 | - | - | 2.0 |
| Re-C1 | A-3 | 77.0 | B-3 | 18.0 | C-2 | 5.0 | - | - | 2.0 |
| Re-C2 | A-2 | 78.0 | B-2 | 22.0 | - | - | - | - | 2.0 |

**Table 3**

| Table 2 (2) | Solvent (F) | | Compound Y | Compound Y1 | Compound Y2 | Metal X | Y/X | Peroxide |
|---|---|---|---|---|---|---|---|---|
| | Type | Mixing ratio | Amount (ppm) | Amount (ppm) | Amount (ppm) | Amount (ppm) | | Amount (ppm) |
| Re-1 | F-1/F-2 | 80/20 | 50 | 50 | 0 | 1.00E-07 | 5.00E+08 | 8 |
| Re-2 | F-1/F-2 | 40/60 | 0.5 | 0.5 | 0 | 1.00E-02 | 5.00E+01 | 5 |
| Re-3 | F-1/F-3/F-4 | 81/10/10 | 150 | 150 | 0 | 5.00E-03 | 3.00E+04 | 3 |
| Re-4 | F-1/F-5 | 90/10 | 0.2 | 0.2 | 0 | 4.00E-04 | 5.00E+02 | 4 |
| Re-5 | F-1/F-2 | 20/80 | 30 | 15 | 15 | 6.00E-06 | 5.00E+06 | 12 |
| Re-6 | F-1/F-2/F-6/F-3 | 85/7/7/1 | 4 | 4 | 0 | 2.00E-05 | 2.00E+05 | 6 |
| Re-7 | F-1/F-2 | 85/15 | 30 | 30 | 0 | 3.00E-04 | 1.00E+05 | 80 |
| Re-C1 | F-1/F-5 | 85/15 | 0.5 | 0.5 | 0 | 1.00E-01 | 5.00E+00 | 9 |
| Re-C2 | F-1/F-2 | 40/60 | 50000 | 50000 | 0 | 1.00E-05 | 5.00E+09 | 5 |

**Table 4**

| Table 2 (3) | Resin (A) | | Photoacid generator (B) | | Acid diffusion control agent (C) | | Hydrophobic resin (E) | | Concentration of solid contents (%) |
|---|---|---|---|---|---|---|---|---|---|
| | Type | Amount (%) | Type | Amount (%) | Type | Amount (%) | Type | Amount (%) | |
| Re-8 | A-1 | 84.0 | B-1 | 12.0 | C-3 | 4.0 | - | - | 2.0 |
| Re-9 | A-3 | 75.5 | B-2 | 22.0 | C-1 | 2.5 | - | - | 2.4 |
| Re-10 | A-4 | 78.0 | B-3 | 16.0 | C-2 | 6.0 | - | - | 2.0 |
| Re-11 | A-5 | 82.0 | B-4 | 14.0 | C-3 | 4.0 | - | - | 2.0 |
| Re-12 | A-5 | 79.0 | B-5 | 18.0 | C-4 | 3.0 | - | - | 2.2 |
| Re-13 | A-2 | 76.0 | B-6 | 20.0 | C-3 | 4.0 | - | - | 1.8 |
| Re-14 | A-5 | 78.0 | B-5 | 18.0 | C-3 | 4.0 | - | - | 2.0 |

**Table 5**

| Table 2 (4) | Solvent (F) | | Compound Y | Compound Y1 | Compound Y2 | Compound Y3 | Compound Y4 | Compound Y5 | Metal X | Y/X | Peroxide |
|---|---|---|---|---|---|---|---|---|---|---|---|
| | Type | Mixing ratio | Amount (ppm) | Amount (ppm) | Amount (ppm) | Amount (ppm) | Amount (ppm) | Amount (ppm) | Amount (ppm) | | Amount (ppm) |
| Re-8 | F-1/F-2 | 20/80 | 30 | 2 | 28 | 0 | 0 | 0 | 6.00E-06 | 5.00E+06 | 8 |
| Re-9 | F-1/F-2 | 40/60 | 10 | 0 | 10 | 0 | 0 | 0 | 2.00E-05 | 5.00E+05 | 5 |
| Re-10 | F-1/F-3/F-4 | 80/10/10 | 30 | 0 | 0 | 30 | 0 | 0 | 6.00E-06 | 5.00E+06 | 10 |
| Re-11 | F-1/F-5 | 90/10 | 50 | 1 | 0 | 0 | 49 | 0 | 4.00E-04 | 1.25E+05 | 12 |
| Re-12 | F-1/F-2 | 20/80 | 5 | 0 | 0 | 0 | 0 | 5 | 6.00E-06 | 8.33E+05 | 10 |
| Re-13 | F-1/F-5 | 90/10 | 2 | 1 | 0 | 1 | 0 | 0 | 4.00E-04 | 5.00E+03 | 8 |
| Re-14 | F-1/F-2 | 20/80 | 20 | 5 | 5 | 5 | 5 | 0 | 6.00E-06 | 3.33E+06 | 6 |

### Measurement and Evaluation of Resist Composition

### Determination of Requirement 1

Resist compositions shown in Table 2 were each applied onto a silicon wafer having a diameter of 12 inches, and each coating film was baked at 120°C for 60 seconds to form a resist film having a thickness of 50 nm. The silicon wafer having the resist film was immersed in a mixed solution which included butyl acetate and undecane and in which the mass ratio of butyl acetate:undecane was 9:1 to remove the resist film from the silicon wafer. The silicon wafer from which the resist film had been removed was taken out of the mixed solution and spin dried.

The surface of the resulting silicon wafer was inspected with a defect evaluation apparatus "UVision 8" (manufactured by Applied Materials, Inc.) to make a defect map showing the location of defects detected on the surface of the silicon wafer. Thereafter, a defect image was obtained using SEMVision G4 (manufactured by Applied Materials, Inc.), and the number of defects per silicon wafer was calculated by comparing the defect image with the defect map.

Resist compositions whose calculated number of defects per silicon wafer was in the range of 1 to 1000 were determined to satisfy requirement 1, and resist compositions whose calculated number of defects per silicon wafer was less than 1 or more than 1000 were determined not to satisfy requirement 1.

In the "Requirement 1" column in Table 3 given later, "A" means that requirement 1 is satisfied, and "B" means that requirement 1 is not satisfied.

### Formation of Resist Pattern and Measurement of Number of Defects (1)

A composition AL412 for underlayer film formation (manufactured by Brewer Science, Inc.) was applied onto a silicon wafer having a diameter of 12 inches and baked at 205°C for 60 seconds to form an underlayer film made of an organic film having a thickness of 20 nm. The resist compositions shown in Table 2 were each applied thereto, and each coating film was baked at 120°C for 60 seconds to form a resist film having a thickness of 50 nm.

The silicon wafer having the resist film obtained by the above procedure was subjected to pattern exposure at an exposure dose of 30 mJ/cm² using an EUV exposure apparatus (NXE3400 manufactured by ASML; NA, 0.33; Quadrupol; outer sigma, 0.885; inner sigma, 0.381). As a reticle, a mask having a line width of 25 nm and a line-to-space ratio of 1:1 in terms of on-wafer dimensions was used.

The resist film subjected to pattern exposure was baked (PEB) at 110°C for 60 seconds, and then the silicon wafer having the resist film was immersed in a developer shown in Table 3 below and developed for 30 seconds. The silicon wafer having the resist film was taken out of the developer and spin dried to thereby obtain a silicon wafer on which a resist pattern formed of a line-and-space pattern with a pitch of 50 nm was formed.

The silicon wafer on which the resist pattern was formed was inspected with a defect evaluation apparatus "UVision 8" (manufactured by Applied Materials, Inc.) to make a defect map. Thereafter, a defect image was obtained using SEMVision G4 (manufactured by Applied Materials, Inc.), and the number of pattern defects per silicon wafer (the number of pattern defects) was calculated.

### Pattern Formation of Silicon Wafer and Measurement of Number of Defects (2)

Using an etching apparatus (product name "Tactras Vigus", manufactured by Tokyo Electron Ltd.), the silicon wafer having the resist pattern produced in the above manner was subjected to a dry etching treatment (oxygen plasma etching) of the underlayer film using the resist pattern as a mask. The dry etching treatment was performed until the surface of the silicon wafer was exposed, thereby forming a pattern in the underlayer film.

Thereafter, the number of defects was measured by the same method as the above method of measuring the number of defects of the resist pattern, thereby measuring the number of defects of the pattern formed in the underlayer film and the resist pattern (the total number of defects). Subsequently, the number of defects of the resist pattern was subtracted from the total number of defects to calculate the number of defects of the pattern formed in the underlayer film.

### Evaluation of Preservation Stability

A storage test was performed in which each of the resist compositions produced in Examples and Comparative Example was housed in a container and stored in a thermostatic chamber at 35°C for 3 months. After the storage period elapsed, a resist pattern was formed, and the number of defects of the resist pattern formed was measured by the same method as the above method of measuring the number of defects of the resist pattern.

Using the ratio of the number of defects of the resist pattern formed using the resist composition after storage to the number of defects of the resist pattern formed using the resist composition immediately after production (before storage) {(number of defects after storage)/ (number of defects before storage), also referred to as "the degree of increase in defect before and after the storage test"}, the preservation stability of the resist composition was evaluated according to the following evaluation criteria.

### Evaluation Criteria

A: The degree of increase in defect before and after the storage test is less than 1.1 times.
B: The degree of increase in defect before and after the storage test is 1.1 times or more and less than 2 times.
C: The degree of increase in defect before and after the storage test is 2 times or more.

Table 3 below shows the resist compositions and developer used in Examples and Comparative Examples, the results of the above measurements, and the results of the above evaluation.

In the table, "nBA/UD" in the "Developer" column represents a mixed solution of butyl acetate and undecane (butyl acetate:undecane = 90:10 (mass ratio)).

In the table, the "Number of resist pattern defects (1)" column represents the number of defects of a resist pattern per silicon wafer, the "Number of defects after etching (2)" column represents the sum of the number of defects of a pattern formed in an underlayer film per silicon wafer and the number of defects of a resist pattern per silicon wafer, and the "(2) - (1)" column represents the number of defects of a pattern formed in an underlayer film per silicon wafer.

**Table 6**

| Table 3 | Resist compositio n | Develope r | Requirement 1 | | Evaluation | | | |
|---|---|---|---|---|---|---|---|---|
| | | | Numbe r of defects after resist remova l (pcs) | Determinatio n | Numbe r of resist pattern defects (1) (pcs) | Numbe r of defects after etching (2) (pcs) | (2) - (1) (pcs) | Preservatio n stability |
| Example 1 | Re-1 | nBA/UD | 80 | A | 90 | 100 | 10 | B |
| Example 2 | Re-2 | nBA/UD | 20 | A | 30 | 70 | 40 | A |
| Example 3 | Re-3 | nBA/UD | 150 | A | 170 | 195 | 25 | A |
| Example 4 | Re-4 | nBA/UD | 10 | A | 15 | 35 | 20 | A |
| Example 5 | Re-5 | nBA/UD | 60 | A | 70 | 80 | 10 | A |
| Example 6 | Re-6 | nBA/UD | 40 | A | 50 | 65 | 15 | A |
| Example 7 | Re-7 | nBA/UD | 200 | A | 40 | 90 | 50 | B |
| Example 8 | Re-8 | nBA/UD | 60 | A | 90 | 100 | 10 | A |
| Example 9 | Re-9 | nBA/UD | 30 | A | 30 | 50 | 20 | A |
| Example 10 | Re-10 | nBA/UD | 120 | A | 120 | 140 | 20 | A |
| Example 11 | Re-11 | nBA/UD | 10 | A | 5 | 20 | 15 | A |
| Example 12 | Re-12 | nBA/UD | 50 | A | 60 | 80 | 20 | A |
| Example 13 | Re-13 | nBA/UD | 40 | A | 30 | 45 | 15 | A |
| Example 14 | Re-14 | nBA/UD | 180 | A | 30 | 50 | 20 | A |
| Comparativ e Example 1 | Re-C1 | nBA/UD | 2000 | B | 1500 | 14000 | 1250 0 | A |
| Comparativ e Example 2 | Re-C2 | nBA/UD | 2500 | B | 3000 | 15000 | 1200 0 | C |

### Examples 15 to 124

As a developer, a developer including organic solvents shown in Table 4 below was used. Except for this, a resist pattern was formed using a resist composition shown in Table 2 and the number of pattern defect defects per silicon wafer was determined according to the method described in Formation of Resist Pattern and Measurement of Number of Defects (1) above, and the produced silicon wafer having the resist pattern was subjected to a dry etching treatment and the number of defects of a pattern formed in the underlayer film was determined according to the method described in Pattern Formation of Silicon Wafer and Measurement of Number of Defects (2) above.

As a developer, organic solvents S-1 to S-18 below were used.
S-1: undecane (manufactured by FUJIFILM Wako Pure Chemical Corporation, "Wako Special Grade")
S-2: decane (manufactured by FUJIFILM Wako Pure Chemical Corporation, "Wako Special Grade")
S-3: dodecane (manufactured by FUJIFILM Wako Pure Chemical Corporation, "Wako Special Grade")
S-4: 2-methyldecane (manufactured by FUJIFILM Wako Pure Chemical Corporation)
S-5: nonane (manufactured by FUJIFILM Wako Pure Chemical Corporation, "Wako Special Grade")
S-6: butyl acetate (manufactured by FUJIFILM Wako Pure Chemical Corporation, "Wako Special Grade")
S-7: isobutyl acetate (manufactured by FUJIFILM Wako Pure Chemical Corporation, "Wako Special Grade")
S-8: t-butyl acetate (manufactured by FUJIFILM Wako Pure Chemical Corporation, "Wako Special Grade")
S-9: amyl acetate (manufactured by FUJIFILM Wako Pure Chemical Corporation, "Wako Special Grade")
S-10: isoamyl acetate (manufactured by FUJIFILM Wako Pure Chemical Corporation, "Wako Special Grade")
S-11: propyl propionate (manufactured by FUJIFILM Wako Pure Chemical Corporation, "Wako Special Grade")
S-12: butyl propionate (manufactured by FUJIFILM Wako Pure Chemical Corporation, "Wako Special Grade")
S-13: isobutyl propionate (manufactured by FUJIFILM Wako Pure Chemical Corporation, "Wako Special Grade")
S-14: ethyl butyrate (manufactured by FUJIFILM Wako Pure Chemical Corporation, "Wako Special Grade")
S-15: isoamyl formate (manufactured by FUJIFILM Wako Pure Chemical Corporation, "Wako Special Grade")
S-16: propyl butyrate (manufactured by Tokyo Chemical Industry Co., Ltd.)
S-17: isopropyl butyrate (manufactured by FUJIFILM Wako Pure Chemical Corporation)
S-18: propyl isobutyrate (manufactured by Tokyo Chemical Industry Co., Ltd.)

In Table 4, the "Type" columns of "Developer" each represent the type of an organic solvent included in a developer in each Example, and the "Amount (%)" columns of "Developer" each represent the content (mass%) of each organic solvent relative to the total amount of the developer.

The "Number of resist pattern defects (1)" column, the "Number of defects after etching (2)" column, and the "(2) - (1)" column in Table 4 represent the same as the columns in Table 3.

**Table 7**

| Table 4 (1) | Resist composition | Developer | | | | | | Evaluation | | |
|---|---|---|---|---|---|---|---|---|---|---|
| | | Solvent 1 | | Solvent 2 | | Solvent 3 | | Number of resist pattern defects (1) (pcs) | Number of defects after etching (2) (pcs) | (2) - (1) (pcs) |
| | | Type | Amount (%) | Type | Amount (%) | Type | Amount (%) | | | |
| Example 15 | Re-2 | S-15 | 97 | S-1 | 3 | - | - | 26 | 55 | 29 |
| Example 16 | Re-3 | S-15 | 53 | S-2 | 17 | S-6 | 30 | 52 | 71 | 19 |
| Example 17 | Re-5 | S-15 | 79 | S-3 | 21 | - | - | 27 | 37 | 10 |
| Example 18 | Re-2 | S-15 | 76 | S-4 | 24 | - | - | 31 | 61 | 30 |
| Example 19 | Re-3 | S-15 | 89 | S-5 | 11 | - | - | 54 | 64 | 10 |
| Example 20 | Re-5 | S-6 | 97 | S-1 | 3 | - | - | 57 | 74 | 17 |
| Example 21 | Re-2 | S-6 | 79 | S-2 | 21 | - | - | 15 | 38 | 23 |
| Example 22 | Re-3 | S-6 | 96 | S-3 | 4 | - | - | 43 | 64 | 21 |
| Example 23 | Re-5 | S-6 | 80 | S-4 | 20 | - | - | 18 | 41 | 23 |
| Example 24 | Re-2 | S-6 | 87 | S-5 | 13 | - | - | 48 | 60 | 12 |
| Example 25 | Re-3 | S-7 | 85 | S-1 | 15 | - | - | 28 | 48 | 20 |
| Example 26 | Re-5 | S-7 | 87 | S-2 | 13 | - | - | 24 | 43 | 19 |
| Example 27 | Re-2 | S-7 | 82 | S-3 | 18 | - | - | 44 | 69 | 25 |
| Example 28 | Re-3 | S-7 | 49 | S-4 | 11 | S-6 | 40 | 15 | 28 | 13 |
| Example 29 | Re-5 | S-7 | 90 | S-5 | 10 | - | - | 55 | 65 | 10 |
| Example 30 | Re-2 | S-8 | 84 | S-1 | 16 | - | - | 56 | 85 | 29 |
| Example 31 | Re-3 | S-8 | 96 | S-2 | 4 | - | - | 59 | 70 | 11 |
| Example 32 | Re-5 | S-8 | 93 | S-3 | 7 | - | - | 41 | 66 | 25 |
| Example 33 | Re-2 | S-8 | 89 | S-4 | 11 | - | - | 49 | 65 | 16 |
| Example 34 | Re-3 | S-8 | 76 | S-5 | 24 | - | - | 59 | 85 | 26 |
| Example 35 | Re-5 | S-11 | 96 | S-1 | 4 | - | - | 50 | 72 | 22 |
| Example 36 | Re-2 | S-11 | 82 | S-2 | 18 | - | - | 27 | 45 | 18 |
| Example 37 | Re-3 | S-11 | 78 | S-3 | 22 | - | - | 53 | 83 | 30 |
| Example 38 | Re-5 | S-11 | 87 | S-4 | 13 | - | - | 46 | 66 | 20 |
| Example 39 | Re-2 | S-11 | 76 | S-5 | 24 | - | - | 24 | 37 | 13 |
| Example 40 | Re-3 | S-14 | 98 | S-1 | 2 | - | - | 29 | 53 | 24 |
| Example 41 | Re-5 | S-14 | 88 | S-2 | 12 | - | - | 31 | 53 | 22 |
| Example 42 | Re-2 | S-14 | 78 | S-3 | 22 | - | - | 32 | 58 | 26 |
| Example 43 | Re-3 | S-14 | 75 | S-4 | 25 | - | - | 37 | 59 | 22 |
| Example 44 | Re-5 | S-14 | 76 | S-5 | 24 | - | - | 36 | 58 | 22 |

**Table 8**

| Table 4 (2) | Resist composition | Developer | | | | | | Evaluation | | |
|---|---|---|---|---|---|---|---|---|---|---|
| | | Solvent 1 | | Solvent 2 | | Solvent 3 | | Number of resist pattern defects (1) (pcs) | Number of defects after etching (2) (pcs) | (2) - (1) (pcs) |
| | | Type | Amount (%) | Type | Amount (%) | Type | Amount (%) | | | |
| Example 45 | Re-2 | S-9 | 76 | S-1 | 24 | - | - | 38 | 62 | 24 |
| Example 46 | Re-3 | S-9 | 93 | S-2 | 7 | - | - | 35 | 61 | 26 |
| Example 47 | Re-5 | S-9 | 87 | S-3 | 13 | - | - | 50 | 71 | 21 |
| Example 48 | Re-2 | S-9 | 75 | S-4 | 25 | - | - | 25 | 46 | 21 |
| Example 49 | Re-3 | S-9 | 86 | S-5 | 14 | - | - | 37 | 52 | 15 |
| Example 50 | Re-5 | S-10 | 77 | S-1 | 23 | - | - | 25 | 44 | 19 |
| Example 51 | Re-2 | S-10 | 81 | S-2 | 19 | - | - | 16 | 32 | 16 |
| Example 52 | Re-3 | S-10 | 81 | S-3 | 19 | - | - | 36 | 47 | 11 |
| Example 53 | Re-5 | S-10 | 98 | S-4 | 2 | - | - | 24 | 53 | 29 |
| Example 54 | Re-2 | S-10 | 87 | S-5 | 13 | - | - | 59 | 77 | 18 |
| Example 55 | Re-3 | S-12 | 92 | S-1 | 8 | - | - | 39 | 52 | 13 |
| Example 56 | Re-5 | S-12 | 87 | S-2 | 13 | - | - | 47 | 77 | 30 |
| Example 57 | Re-2 | S-12 | 89 | S-3 | 11 | - | - | 35 | 55 | 20 |
| Example 58 | Re-3 | S-12 | 87 | S-4 | 13 | - | - | 50 | 71 | 21 |
| Example 59 | Re-5 | S-12 | 90 | S-5 | 10 | - | - | 18 | 47 | 29 |
| Example 60 | Re-2 | S-13 | 86 | S-1 | 14 | - | - | 20 | 47 | 27 |
| Example 61 | Re-3 | S-13 | 96 | S-2 | 4 | - | - | 33 | 55 | 22 |
| Example 62 | Re-5 | S-13 | 82 | S-3 | 18 | - | - | 15 | 25 | 10 |
| Example 63 | Re-2 | S-13 | 92 | S-4 | 8 | - | - | 43 | 69 | 26 |
| Example 64 | Re-3 | S-13 | 88 | S-5 | 12 | - | - | 27 | 54 | 27 |
| Example 65 | Re-5 | S-16 | 98 | S-1 | 2 | - | - | 53 | 65 | 12 |
| Example 66 | Re-2 | S-16 | 82 | S-2 | 18 | - | - | 31 | 58 | 27 |
| Example 67 | Re-3 | S-16 | 85 | S-3 | 15 | - | - | 55 | 75 | 20 |
| Example 68 | Re-5 | S-16 | 87 | S-4 | 13 | - | - | 17 | 45 | 28 |
| Example 69 | Re-2 | S-16 | 83 | S-5 | 17 | - | - | 56 | 83 | 27 |
| Example 70 | Re-3 | S-17 | 93 | S-1 | 7 | - | - | 33 | 55 | 22 |
| Example 71 | Re-5 | S-17 | 95 | S-2 | 5 | - | - | 38 | 57 | 19 |
| Example 72 | Re-2 | S-17 | 85 | S-3 | 15 | - | - | 42 | 52 | 10 |
| Example 73 | Re-3 | S-17 | 83 | S-4 | 17 | - | - | 43 | 58 | 15 |
| Example 74 | Re-5 | S-17 | 80 | S-5 | 20 | - | - | 42 | 55 | 13 |

**Table 9**

| Table 4 (3) | Resist composition | Developer | | | | | | Evaluation | | |
|---|---|---|---|---|---|---|---|---|---|---|
| | | Solvent 1 | | Solvent 2 | | Solvent 3 | | Number of resist pattern defects (1) (pcs) | Number of defects after etching (2) (pcs) | (2)-(1) (pcs) |
| | | Type | Amount (%) | Type | Amount (%) | Type | Amount (%) | | | |
| Example 75 | Re-2 | S-18 | 82 | S-1 | 18 | - | - | 55 | 75 | 20 |
| Example 76 | Re-3 | S-18 | 81 | S-2 | 19 | - | - | 31 | 43 | 12 |
| Example 77 | Re-5 | S-18 | 80 | S-3 | 20 | - | - | 45 | 66 | 21 |
| Example 78 | Re-2 | S-18 | 80 | S-4 | 20 | - | - | 16 | 44 | 28 |
| Example 79 | Re-3 | S-18 | 82 | S-5 | 18 | - | - | 27 | 45 | 18 |
| Example 80 | Re-5 | S-15 | 26 | S-1 | 23 | S-10 | 51 | 44 | 63 | 19 |
| Example 81 | Re-2 | S-15 | 46 | S-2 | 18 | S-10 | 36 | 44 | 59 | 15 |
| Example 82 | Re-3 | S-15 | 48 | S-3 | 3 | S-10 | 49 | 33 | 44 | 11 |
| Example 83 | Re-5 | S-15 | 54 | S-4 | 4 | S-10 | 42 | 46 | 69 | 23 |
| Example 84 | Re-2 | S-15 | 35 | S-5 | 7 | S-10 | 58 | 20 | 42 | 22 |
| Example 85 | Re-3 | S-15 | 30 | S-1 | 25 | S-13 | 45 | 17 | 28 | 11 |
| Example 86 | Re-5 | S-15 | 63 | S-2 | 20 | S-13 | 17 | 43 | 56 | 13 |
| Example 87 | Re-2 | S-15 | 52 | S-3 | 15 | S-13 | 33 | 26 | 41 | 15 |
| Example 88 | Re-3 | S-15 | 40 | S-4 | 11 | S-13 | 49 | 33 | 56 | 23 |
| Example 89 | Re-5 | S-15 | 27 | S-5 | 16 | S-13 | 57 | 20 | 49 | 29 |
| Example 90 | Re-2 | S-15 | 43 | S-1 | 6 | S-16 | 51 | 48 | 73 | 25 |
| Example 91 | Re-3 | S-15 | 48 | S-2 | 23 | S-16 | 29 | 43 | 71 | 28 |
| Example 92 | Re-5 | S-15 | 62 | S-3 | 25 | S-16 | 13 | 27 | 49 | 22 |
| Example 93 | Re-2 | S-15 | 42 | S-4 | 5 | S-16 | 53 | 40 | 51 | 11 |
| Example 94 | Re-3 | S-15 | 73 | S-5 | 2 | S-16 | 25 | 57 | 87 | 30 |
| Example 95 | Re-5 | S-6 | 46 | S-1 | 24 | S-10 | 30 | 32 | 52 | 20 |
| Example 96 | Re-2 | S-6 | 52 | S-2 | 4 | S-10 | 44 | 54 | 79 | 25 |
| Example 97 | Re-3 | S-6 | 30 | S-3 | 19 | S-10 | 51 | 43 | 69 | 26 |
| Example 98 | Re-5 | S-6 | 50 | S-4 | 10 | S-10 | 40 | 27 | 44 | 17 |
| Example 99 | Re-2 | S-6 | 41 | S-5 | 16 | S-10 | 43 | 59 | 69 | 10 |

**Table 10**

| Table 4 (4) | Resist composition | Developer | | | | | | Evaluation | | |
|---|---|---|---|---|---|---|---|---|---|---|
| | | Solvent 1 | | Solvent 2 | | Solvent 3 | | Number of resist pattern defects (1) (pcs) | Number of defects after etching (2) (pcs) | (2) - (1) (pcs) |
| | | Type | Amount (%) | Type | Amount (%) | Type | Amount (%) | | | |
| Example 100 | Re-3 | S-6 | 59 | S-1 | 8 | S-12 | 33 | 42 | 62 | 20 |
| Example 101 | Re-5 | S-6 | 59 | S-2 | 23 | S-12 | 18 | 42 | 63 | 21 |
| Example 102 | Re-2 | S-6 | 57 | S-3 | 4 | S-12 | 39 | 34 | 47 | 13 |
| Example 103 | Re-3 | S-6 | 57 | S-4 | 5 | S-12 | 38 | 19 | 44 | 25 |
| Example 104 | Re-5 | S-6 | 42 | S-5 | 7 | S-12 | 51 | 20 | 43 | 23 |
| Example 105 | Re-2 | S-6 | 20 | S-1 | 22 | S-16 | 58 | 39 | 58 | 19 |
| Example 106 | Re-3 | S-6 | 73 | S-2 | 6 | S-16 | 21 | 57 | 86 | 29 |
| Example 107 | Re-5 | S-6 | 40 | S-3 | 6 | S-16 | 54 | 28 | 42 | 14 |
| Example 108 | Re-2 | S-6 | 61 | S-4 | 9 | S-16 | 30 | 38 | 54 | 16 |
| Example 109 | Re-3 | S-6 | 33 | S-5 | 12 | S-16 | 55 | 33 | 50 | 17 |
| Example 110 | Re-5 | S-7 | 78 | S-1 | 2 | S-10 | 20 | 56 | 66 | 10 |
| Example 111 | Re-2 | S-7 | 39 | S-2 | 10 | S-10 | 51 | 52 | 82 | 30 |
| Example 112 | Re-3 | S-7 | 73 | S-3 | 11 | S-10 | 16 | 26 | 42 | 16 |
| Example 113 | Re-5 | S-7 | 38 | S-4 | 3 | S-10 | 59 | 21 | 33 | 12 |
| Example 114 | Re-2 | S-7 | 62 | S-5 | 10 | S-10 | 28 | 60 | 70 | 10 |
| Example 115 | Re-3 | S-7 | 35 | S-1 | 15 | S-13 | 50 | 20 | 39 | 19 |
| Example 116 | Re-5 | S-7 | 33 | S-2 | 12 | S-13 | 55 | 35 | 47 | 12 |
| Example 117 | Re-2 | S-7 | 63 | S-3 | 11 | S-13 | 26 | 56 | 75 | 19 |
| Example 118 | Re-3 | S-7 | 59 | S-4 | 17 | S-13 | 24 | 43 | 56 | 13 |
| Example 119 | Re-5 | S-7 | 37 | S-5 | 11 | S-13 | 52 | 55 | 78 | 23 |
| Example 120 | Re-3 | S-7 | 50 | S-1 | 21 | S-16 | 29 | 21 | 37 | 16 |
| Example 121 | Re-5 | S-7 | 43 | S-2 | 20 | S-16 | 37 | 33 | 46 | 13 |
| Example 122 | Re-2 | S-7 | 73 | S-3 | 6 | S-16 | 21 | 37 | 62 | 25 |
| Example 123 | Re-3 | S-7 | 41 | S-4 | 10 | S-16 | 49 | 17 | 31 | 14 |
| Example 124 | Re-5 | S-7 | 54 | S-5 | 6 | S-16 | 40 | 28 | 50 | 22 |

The evaluation results shown in the above tables have confirmed that the resist composition according to the present invention has high preservation stability and is characterized in that when etching treatment is performed using a resist pattern formed using the resist composition as a mask, defects are less likely to occur in a pattern formed.

## Claims

1. An actinic ray-sensitive or radiation-sensitive resin composition comprising:
a resin that becomes more polar under action of acid;
a photoacid generator;
a compound Y that is at least one selected from the group consisting of a compound represented by formula (1) below and a compound represented by formula (2) below; and
a metal atom,
wherein a mass ratio of a content of the compound Y to a content of the metal atom is 1.0 × 10 to 1.0 × 10⁹, 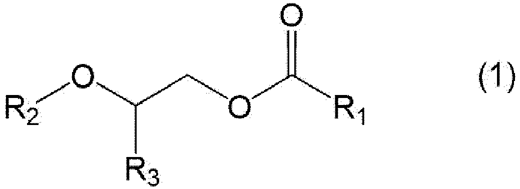 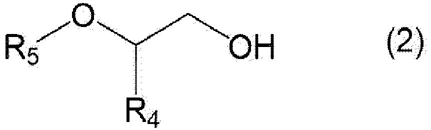
in formula (1), R₁ to R₃ each independently represent an alkyl group having 1 to 5 carbon atoms, and
in formula (2), R₄ and R₅ each independently represent an alkyl group having 1 to 5 carbon atoms.

2. The actinic ray-sensitive or radiation-sensitive resin composition according to claim 1, satisfying requirement 1 below,
Requirement 1: the actinic ray-sensitive or radiation-sensitive resin composition is applied to a surface of a silicon wafer having a diameter of 12 inches, and a resulting coating film is baked at 120°C for 60 seconds to prepare a silicon wafer having a resist film with a thickness of 50 nm; the silicon wafer having the resist film is immersed in a mixed solution which includes butyl acetate and undecane and in which a mass ratio of butyl acetate:undecane is 9:1 to remove the resist film from the silicon wafer; defects on the surface of the silicon wafer from which the resist film has been removed are then measured using a defect evaluation apparatus; and a number of measured defects per silicon wafer is 1 to 1000.

3. The actinic ray-sensitive or radiation-sensitive resin composition according to claim 1 or 2, wherein the resin has a repeating unit represented by formula (Y) below, 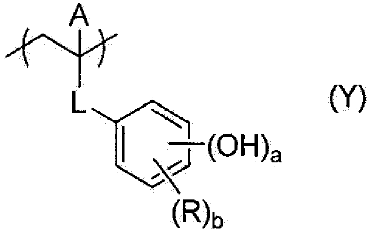
in formula (Y), A represents a hydrogen atom, an alkyl group, a cycloalkyl group, a halogen atom, or a cyano group,
L represents a single bond or a divalent linking group having an oxygen atom,
R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group, when a plurality of R's are present, the plurality of R's may be the same or different and may be bonded to each other to form a ring,
a represents an integer of 1 to 3, and
b represents an integer of 0 to (5 - a).

4. The actinic ray-sensitive or radiation-sensitive resin composition according to claim 1 or 2, further comprising propylene glycol methyl ether acetate.

5. The actinic ray-sensitive or radiation-sensitive resin composition according to claim 1 or 2, further comprising a peroxide,
wherein a content of the peroxide is 100 mass ppm or less relative to a total mass of the actinic ray-sensitive or radiation-sensitive resin composition.

6. The actinic ray-sensitive or radiation-sensitive resin composition according to claim 1 or 2, being used for EUV exposure.

7. A method for producing a resist pattern, comprising:
a resist film formation step of forming a resist film on a substrate using the actinic ray-sensitive or radiation-sensitive resin composition according to claim 1 or 2;
an exposure step of exposing the resist film; and
a development step of developing the exposed resist film using a developer.

8. The method for producing a resist pattern according to claim 7, wherein the developer includes an ester solvent and a hydrocarbon solvent.

9. The method for producing a resist pattern according to claim 7, wherein the developer includes butyl acetate and undecane.
